# EUROPEAN PATENT SPECIFICATION

(11) **EP 1 682 909 B1**
(45) Date of publication and mention of the grant of the patent: **04.04.2012**
(21) Application number: 04767131.8
(22) Date of filing: 21.10.2004
(51) Int. Cl.: G01R 31/08

(54) **METHOD AND APPARATUS FOR IDENTIFYING INTERMITTENT EARTH FAULT**
VERFAHREN UND VORRICHTUNG ZUM IDENTIFIZIEREN EINES IN ABSTÄNDEN AUFTRETENDEN ERDFEHLERS
PROCEDE ET APPAREIL D'IDENTIFICATION DE DEFAUT A LA TERRE INTERMITTENT

(30) Priority: 22.10.2003 FI 20031546
(43) Date of publication of application: 26.07.2006
(73) Proprietor: ABB Oy, 00380 Helsinki (FI)
(72) Inventor: MÄKINEN, Olavi, FI-65370 Vaasa (FI)
(74) Representative: Kaukonen, Juha Veikko
(86) International application number: PCT/FI2004/000625
(87) International publication number: WO 2005/038474

(56) References cited:
- EP-A- 0 267 500
- EP-A1- 1 065 510
- WO-A1-97/08562
- WO-A1-98/20356
- WO-A1-99/10753

## Description

### BACKGROUND OF THE INVENTION

The invention relates to a method for identifying an intermittent earth fault in an electricity distribution network, in which method the intermittent earth fault is identified on the basis of a zero sequence voltage in the electricity distribution network and a sum current of phase currents at the start of a feeder line in the electricity distribution network.

The invention also relates to an apparatus for identifying an intermittent earth fault in an electricity distribution network, which apparatus is arranged to identify the intermittent earth fault on the basis of a zero sequence voltage in the electricity distribution network and a sum current of phase currents at the start of a feeder line in the electricity distribution network.

An earth fault in an electricity distribution network refers to an insulation fault between a phase conductor and earth, or a part in connection with earth, i.e. a fault, in which at least one phase conductor of a feeder line of the electricity distribution network comes in contact with earth one way or the other. In practice, the earth fault is produced, for instance, as an arc resulting from a spark-over in a protective spark gap of a transformer as a tree falls on an overhead line, as a tree branch touches the line or as a phase conductor breaks and hits the ground. The earth fault may occur in one or more phase conductors. Disturbances resulting from the earth fault appear throughout the galvanically connected network. A galvanically connected network refers to the feeders from a substation which are connected to the same busbar system of the substation at said moment of duty.

About 60 to 70% of the faults in the electricity distribution network are earth faults, of which about 80% are single-phase earth faults. A multi-phase earth fault is often produced as a secondary failure to a one-phase earth fault and it results from a spark-over caused by a voltage rise in unfaulted phases or from transient phenomena at the onset of the earth fault. Most of the earth faults are temporary and they disappear either by themselves or as a result of reclosings provided by earth fault protection.

A very large part of the temporary earth faults are so-called intermittent or restriking earth faults, in which an earth fault occurs repeatedly, even so often that at each local maximum or minimum value of phase voltage a spark-over takes place. The intermittent earth fault appears as a peak or pulse of very short duration in phase voltage and phase current measurements or in a zero sequence voltage corresponding to a mean of instantaneous values of phase voltages and in a sum of phase currents, i.e. a sum current. An intermittent earth fault dies very quickly by itself, but as it is repeated over and over again, it strains unnecessarily the electricity distribution network, weakens the isolation capability of the network at the point where it occurs and with time may lead to a permanent earth fault failure, which prevents the faulted part of the network from being used without repairs. The intermittent earth fault also lowers the quality of electricity to be supplied to the clients and it may cause disturbances and failures in sensitive devices connected to the network. For the operability and maintenance of the network it is also important to detect the intermittent earth faults in the network and to identify on which substation feeder a fault occurs so that fault location can be started before a permanent failure is produced and so that necessary network protection measures to be implemented by protective relays of the substation can be directed to the faulted feeder without interfering with the operation of other feeders.

Conventionally the same method has been used for the identification of and protection against the intermittent earth fault as for the identification of and protection against the permanent earth fault. Said solution calculates by means of FFT (Fast Fourier Transform) the amplitude and phase angle of the fundamental component, i.e. the 50 Hz frequency component, of the zero sequence voltage in a galvanically connected network, and the amplitude and phase angle of the fundamental component, i.e. the 50 Hz frequency component, of the sum current at the start of the feeder observed. A permanent earth fault is identified on the feeder observed, when the amplitudes of the 50 Hz frequency components of the zero sequence voltage and the sum current exceed predetermined limit values and the phase angle difference between said 50 frequency components is within a given range. The identification of an intermittent earth fault based on this solution is restored, i.e. zeroed, however, unless a next fault pulse or fault peak appears within a predetermined time limit. This solution has an advantage that an intermittent earth fault is identified by the same method as the actual continuous earth fault, whereby the method may employ the same protective relay settings as the basic earth fault protection. Thus, protection implemented following this principle converts a fault pulse or a fault peak in the sum current at the start of the feeder, by means of FFT, to a computational 50 Hz component, for which a phase angle is determined, in addition to the amplitude. The same is performed on the 50 Hz frequency component appearing in the zero sequence voltage during the intermittent earth fault. However, it is difficult to determine the direction in which the fault appears and consequently to identify the faulted feeder, because the determination of direction is based on the phase difference between the phase angle of the 50 Hz fundamental component of the zero sequence voltage and the phase angle of a very indefinite 50 Hz fundamental component of the sum current. Hence, the method is liable to erroneous starts, because during the fault the phase difference also on unfaulted feeders attains the start range of the relay settings of the solution. Because the duration of the fault current peak is very short, in the order of about 1 ms, and because it is transient in nature, comprising a plurality of different frequencies, the angle determination of the solution based on the 50 Hz fundamental component of a signal is very vague and liable to errors.

Another known manner to identify an intermittent earth fault has been the fulfilment of the following conditions: a) an instantaneous value of the sum current at the start of the feeder exceeds a limit value to be parameterized; b) on a faulted feeder the polarity of the zero sequence current and the polarity of the zero sequence voltage are in the same phase; c) on the unfaulted feeder the polarity of the sum current and the polarity of the zero sequence voltage are in different phases; and d) a counter is used for counting up whenever condition b) is fulfilled and down if condition c) is fulfilled. As the counter attains a set limit, the fault is identified as an intermittent earth fault. The counter is set to zero if an interval between fault pulses or fault peaks caused by the fault exceed a set limit value. This solution is largely based on events in the time domain. Determination of fault direction is made difficult in the method by the fact that both on the faulted feeder and on the unfaulted feeders a sum current pulse consists of a plurality of frequency components. A high-frequency discharge current component, i.e. a discharge current transient, appearing in the sum current pulse may cause an instantaneous value of the sum current on the unfaulted feeder to be in the same phase with the zero sequence voltage at the sampling moment. In that case the protective relays of the feeders may erroneously start for an intermittent earth fault.

Furthermore, EP-A-0267500 discloses a method and device for the location of an earth fault in a conductor in a three-phase electrical power system, wherein the location of an earth fault is based on the analysis of transients caused by the earth fault in the measurement signal representing the sum current and in the measurement signal representing the misalignment voltage of the system star point.

### BRIEF DESCRIPTION OF THE INVENTION

The object of the present invention is to provide a novel and improved method and apparatus for identifying an intermittent earth fault in electricity distribution networks.

The method of the invention is characterized by producing a zero sequence voltage of said electricity distribution network, producing a sum current of the phase currents of said feeder line at the start of the feeder line, filtering said zero sequence voltage such that the filtered zero sequence voltage substantially comprises only the transient component appearing in the intermittent earth fault, filtering said sum current such that the filtered sum current substantially comprises only a transient component appearing in an intermittent earth fault, determining the amplitude and the phase angle of said zero sequence voltage transient component at least at one frequency, determining the amplitude and the phase angle of said sum current transient component at least at one frequency, forming a phase difference between the phase angles of said zero sequence voltage and sum current transient components, comparing the amplitude of said zero sequence voltage transient component with a predetermined set value of said amplitude, comparing said amplitude of the sum current transient component with a predetermined set value of said amplitude, comparing the phase difference between said phase angles of the transient components of the zero sequence voltage and the sum current with a predetermined set value range of said phase difference and if said amplitudes of the transient components of the zero sequence voltage and the sum current exceed the corresponding set values for the amplitudes and if the phase difference between the phase angles of said transient components of the zero sequence voltage and the sum current is within a predetermined set value range, an intermittent earth fault is identified to occur in the electricity distribution network observed.

Further, the apparatus of the invention is characterized by comprising means for producing a zero sequence voltage of said electricity distribution network, means for producing a sum current of the phase currents of said feeder line at the start of the feeder line, means for filtering said zero sequence voltage such that the filtered zero sequence voltage substantially comprises only a transient component appearing in an intermittent earth fault, means for filtering said sum current such that the filtered sum current substantially comprises only a transient component appearing in an intermittent earth fault, means for determining the amplitude and the phase angle of said zero sequence voltage transient component at least at one frequency, means for determining the amplitude and the phase angle of said sum current transient component at least at one frequency, means for forming the phase difference between the phase angles of the said transient components of the zero sequence voltage and the sum current, means for comparing the amplitude of said zero sequence voltage transient component with a predetermined set value for said amplitude, means for comparing the amplitude of said sum current transient component with a predetermined set value for said amplitude, means for comparing the phase difference between the phase angles of said transient components of the zero sequence voltage and the sum current with a predetermined set value range for said phase difference and means for identifying an intermittent earth fault to occur in the electricity distribution network observed if said amplitudes of the transient components of the zero sequence voltage and the sum current exceed the corresponding set values for the amplitudes and if the phase difference between the phase angles of said transient components of the zero sequence voltage and the sum current is within the predetermined set value range.

The basic idea of the invention is that an intermittent earth fault occurring in the electricity distribution network is identified by producing a zero sequence voltage of said electricity distribution network and a sum current of the phase currents of the feeder line at the start of the feeder line and by filtering said zero sequence voltage and said sum current such that the filtered zero sequence voltage and sum current substantially comprise only a transient component appearing in the intermittent earth fault. Further, the basic idea comprises determining the amplitudes and the phase angles of the transient components of the zero sequence voltage and the sum current as well as the difference between the phase angles at least at one frequency and comparing the determined amplitudes and the phase angle difference of the transient components of the zero sequence voltage and the sum current with predetermined corresponding set values, and if said amplitudes of the transient components of the zero sequence voltage and the sum current exceed the corresponding set values for the amplitudes and if the phase difference between the phase angles of the transient components of the zero sequence voltage and the sum current is within the predetermined set value range an intermittent earth fault is identified to occur in the electricity distribution network observed. According to one embodiment of the invention the solution is employed for identifying an intermittent earth fault on the feeder line for which the amplitude and the phase angle of the transient component of the sum current is determined, the employed set value range of the phase difference between the phase angles of the transient components of the zero sequence voltage and the sum current being the angle range ϕ_{b} ± Δϕ, where ϕ_{b} is -90 degrees and Δϕ is 80 degrees, for instance. According to a second embodiment of the invention, as an intermittent earth fault is detected on the feeder line observed, the breaker of said feeder line is controlled to an open position so as to protect the distribution network against the effect of the intermittent earth fault. According to a third embodiment of the invention the solution is employed for identifying the intermittent earth fault in a network lying in the background of the feeder line observed, the employed set value range for the phase difference between the phase angles of the transient components of the zero sequence voltage and the sum current being the angle range -ϕ_{b} ± Δϕ, where ϕ_{b} is -90 degrees and Δϕ is 80 degrees, for instance.

The invention has an advantage that the decision on the identification of an intermittent earth fault is made on the basis of the amplitudes and phase angles of a transient-like change in the sum current pulse and the zero sequence voltage at least at one frequency typical of a transient. So it is possible to avoid the prior art transient problems particularly associated with the reliability of a phase angle of a fundamental frequency component in the distribution network, because the occurred event is observed at the frequency that is typical of it. The solution allows reliable determination of the amplitudes and phase angles of the transients appearing both in the zero sequence voltage and in the sum current. On the basis of the amplitudes of the transients it is possible to determine that the fault concerned is actually caused by earth fault, and on the basis of the phase angles it is possible to determine the direction in which the fault is located with respect to the feeder observed. The solution of the invention can be used for identifying intermittent earth faults either on the feeder observed, for which the sum current is determined or for identifying intermittent earth faults in a background network of said feeder. The solution can further be used for implementing reliable earth fault protection against intermittent earth faults.

### BRIEF DESCRIPTION OF THE DRAWINGS

The invention will be described in greater detail in connection with the attached drawings, wherein

Figure 1 is a schematic and exemplary view of a one-phase earth fault in a compensated electricity distribution network;

Figure 2 is a schematic view of an equivalent coupling of the compensated electricity distribution network during earth fault;

Figure 3 is a schematic view of an apparatus according to the invention;

Figures 4, 6, 7, 9, 10, 12 and 14 show by way of example a sum current of a faulted feeder in various steps of the method according to the invention;

Figures 5, 8, 11, 13 and 15 show by way of example zero sequence voltage of the electricity distribution network in various steps of the method according to the invention;

Figure 16 shows by way of example the phase difference between the zero sequence voltage of the distribution network and the sum current of the faulted feeder during a fault pulse of the intermittent earth fault failure;

Figures 17a, 17b, 17c, 17d and 17e show by way of example the operation of the method according to the invention as observed with respect to the faulted feeder;

Figures 18, 19, 20 and 21 show by way of example the sum current of an unfaulted feeder in various steps of the method according to the invention;

Figure 22 shows by way of example the phase difference between the zero sequence voltage of the distribution network and the sum current of the unfaulted feeder during a fault pulse of the intermittent earth fault failure, and

Figures 23a, 23b, 23c, 23d and 23e show by way of example the operation of the method according to the invention as observed with respect to the unfaulted feeder.

For the sake of clarity, the invention is presented simplified in the figures. Like reference numerals refer to like parts in the figures.

### DETAILED DESCRIPTION OF THE INVENTION

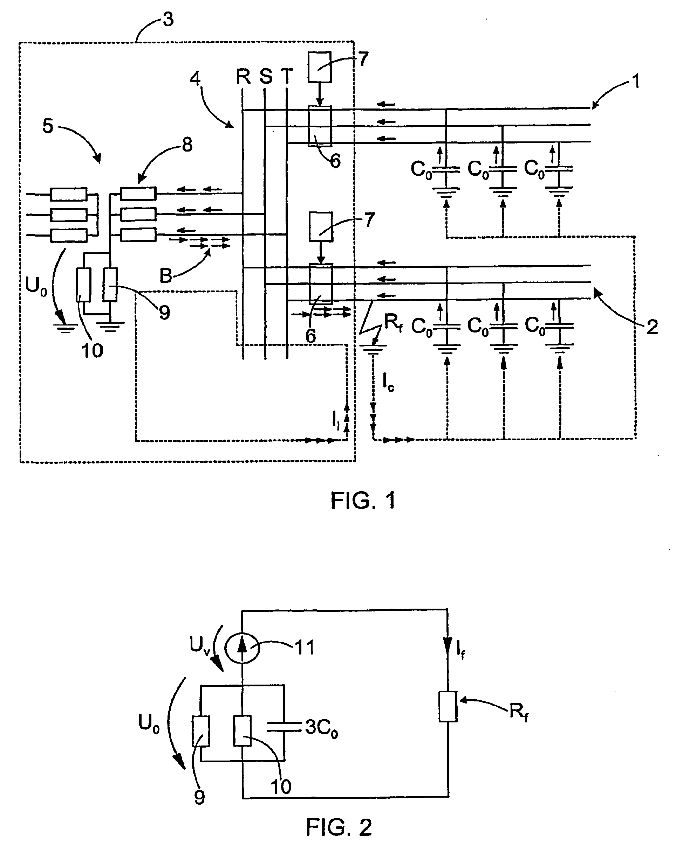

Figure 1 shows schematically an electricity distribution network and a one-phase earth fault occurring therein. The electricity distribution network of Figure 1 has two three-phase feeder lines or feeders, feeder 1 and feeder 2. Feeders 1 and 2 depart from a busbar system 4 of a substation 3 denoted by a broken line, which busbar system is connected to the main transformer 5 of the substation 3. The three different phases in the network are indicated by R, S and T. In the electricity distribution network of Figure1, there are breakers 6 at the beginning of both feeders, and by disconnecting the breakers it is possible to prevent power from being fed into the feeder concerned, for instance, during an ongoing fault on said feeder. Connection and disconnection of the breaker 6 are controlled by protective relays 7, which monitor the state of the network on the basis of the measurements performed on the voltage prevailing in the network and the current flowing in the feeders, and in case an abnormal situation arises, give a control command to disconnect the breaker 6, if necessary.

In the electricity distribution network of Figure 1, a compensation coil 9, whose inductance is L₁, is connected to a star point of a secondary winding of the main transformer 5, i.e. to a network star point, the task of the compensation coil being to compensate the capacitive earth fault current of fundamental frequency generated in the network during the earth fault. The distribution network shown in Figure 1 is thus a compensated, i.e. resonant earthed network, which means that in addition to the network's direct capacitances C₀ to earth the network normally has a connection to earth through the star point of the main transformer 5. Figure 1 also shows an additional load resistance 10, whose resistance is R_{I}, connected in parallel with the compensation coil 9 to the network star point. The task of the additional load resistance 10 is to increase the effective component of the earth fault current generated during the earth fault so as to facilitate earth fault detection. Typically, the additional load resistance 10 is switched on only in case the fault has not disappeared through compensation.

In normal operation the network's direct earth capacitances C₀ are mutually equal, so it is said that the network is symmetrical to earth. The voltage between the star point of the symmetrical network and earth, i.e. the zero sequence voltage, is zero at all times. Likewise, the sum of the network charge currents passing through the network's direct earth capacitances C₀ is zero. As a one-phase earth fault takes place, i.e. as a phase conductor comes in conductive connection with earth either directly or through fault impedance, the voltage of the faulted phase decreases while the voltages of unfaulted phases increase. Due to this asymmetry in voltages, the sum of the network's charge currents differs from zero and forms an earth fault current, i.e. fault current I_{f} that passes to earth through the fault point. Thus, a star point voltage, i.e. zero sequence voltage U₀ is generated between the network's star point and earth. This voltage is equal to the voltage generated by the earth fault current I_{f} as it passes through the direct earth capacitances C₀.

Figure 1 shows a capacitive earth fault current I_{c} and a zero sequence voltage U₀ generated in a one-phase earth fault in the compensated network, when phase T of the feeder 2 gets into conductive connection with earth through a fault resistance R_{f}. In Figure 1, arrow B depicts, by way of example, the flow of the capacitive earth fault current I_{c} in the network. The resistance of the fault resistance R_{f} is the total resistance between the faulted phase conductor and the conductive earth. The capacitance C₀ is the direct earth capacitance of one phase of a three-phase network. During an earth fault the current flowing to earth through the fault resistance R_{f} heads both for the load and for the supplying network in the ground. The current passing in earth, i.e. the earth current, is at its highest at the fault point. The earth current reduces towards the extremities of the feeders as the current rises through direct earth capacitances C₀ to unfaulted phases such that at the ends of the feeders the earth current is zero. The charge currents of the unfaulted phases circulate through transformers to the faulted phase and further to the fault point. Thus the whole galvanically connected network participates in feeding earth fault current I_{f}. During the earth fault the zero sequence voltage U₀ produces in the compensation coil 9 an inductive current Iₗ that is opposite to the capacitive earth fault current I_{c}, which inductive current tends to compensate the earth fault current passing in the fault point. The resonant earthed network is fully compensated when the inductive reactance of the coil corresponds to the capacitive reactance of the network at the operating frequency of the network. In the earth fault of the compensated network most of the earth fault current passes through the compensation coil 9 and only the so-called residual current component of the earth fault current passes through the fault point, the residual current component consisting of an inductive or capacitive idle current resulting from inaccurate tuning of the compensation coil 9, of the effective current resulting from network losses and current harmonics resulting from the saturation of the coil. The residual current component of the earth fault current is the sum of the current I_{c} rising to unfaulted phases through direct earth capacitances, of the inductive current Iₗ of the compensation coil 9 and the effective current Iᵣ passing through the additional load resistance, i.e. I_{f} = I_{c} + Iₗ + Iᵣ, where the underline denotes a vector sum. Figure 2 also shows a schematic view of an equivalent coupling in a earth fault circuit of a compensated network, where the network phase voltage Uᵥ corresponds to a voltage source 11 in accordance with the Thévenin's theorem known per se to the person skilled in the art. Compensated networks may also employ partial compensation, whereby only part of the capacitive earth fault current will be compensated by means of the compensation coil 9.

The basic principles of the earth fault phenomenon are known per se to the person skilled in the art, and therefore it will not be described herein in greater detail. The earth fault phenomenon has been discussed in greater detail for instance in Electricity distribution network design by Lakervi E. & Holmes E. J., London United Kingdom, Peter Peregrinus Ltd., 1989, 320 p.

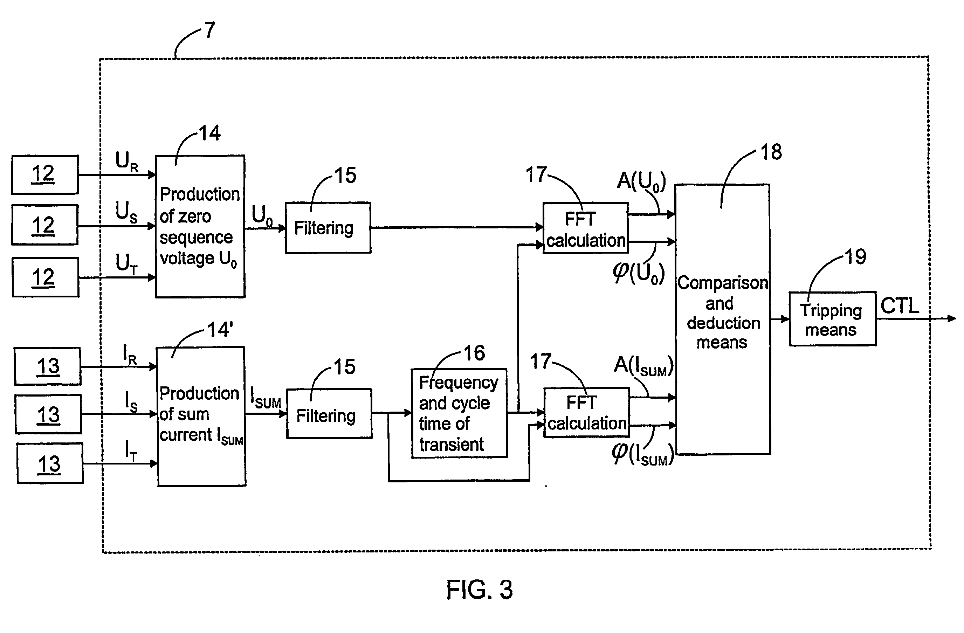

Figure 3 shows schematically an apparatus solution for identifying an intermittent earth fault, which solution is based on charge or discharge transients typical of changes taking place at the onset of the earth fault. The earth fault produces a change in the electrical network, in which the voltage of the faulted phase drops and its direct earth capacitances C₀ discharge and produce a discharge transient. At the same time, voltages of the unfaulted phases rise and their earth capacitances C₀ become charged producing a charge transient. During the discharge transient the charge in the earth capacitances C₀ of the faulted phase is discharged oscillating between the earth fault point and the ends of the feeder. The frequency of the discharge transient varies from 500 Hz up to tens of kilohertz. In theory, the amplitude of the discharge transient may be very high, but in practice it attenuates quickly by the effect of conductor resistance and skin effect as well as fault resistance R_{f} and earth resistance. During the charge transient the earth capacitances of the unfaulted phases become charged. In theory the frequency of the charge transient may be as high as 6 kHz, but in practice the frequency of the charge transient is 100 to 1200 Hz, because the frequency of the transient attenuates, because most of the charge current passes through the winding of the main transformer in the electrical network. As an earth fault takes place at the peak of the phase voltage the voltage of the unfaulted phase may be up to 2.5 times higher than the peak value of the phase voltage prior to the earth fault. Correspondingly, the amplitude of the fault current transient can be up to 10 to 20 times higher than the amplitude of the fundamental frequency fault current.

The solution for identifying the intermittent earth fault is based on charge and discharge transients appearing in the sum current I_{SUM} of the feeder and the zero sequence voltage U₀ of the electrical network. The zero sequence voltage U₀ can be provided, for instance, by calculating in the calculating means 14 a mean of instantaneous values of the phase voltages U_{R}, U_{S} and U_{T} measured with voltage transducers 12 or voltage sensors 12 in a manner known per se. Alternatively the zero sequence voltage U₀ can also be measured directly with a transducer or sensor measuring the voltage of all phases simultaneously. The sum current I_{SUM_}is obtained in the corresponding manner by calculating in the calculating means 14' the sum of the instantaneous values of the phase currents I_{R}, I_{S} and I_{T} measured with current transducers 13 or current sensors 13 in a manner known per se. Alternatively the sum current I_{SUM} can also be measured directly with a transducer or sensor measuring the current of all phases simultaneously.

After forming the zero sequence voltage U₀ and the sum current I_{SUM} said quantities or signals are filtered with a bandpass filter 15, whose pass band is configured such that from the signal to be filtered it retains the frequency components whose frequencies are on said pass band of the filter 15. Depending on whether a charge transient or a discharge transient appearing at the onset of the earth fault is used for identifying an intermittent earth fault the pass band of the filter 15 is configured for an appropriate frequency range such that only the transient component concerned is retained and lower and higher frequencies are filtered out. Prior to bandpass filtering the frequency of the transient is not known very accurately, so the lower and upper limit frequencies of the pass band of the filter 15 are selected such that on the basis of the knowledge on the network behaviour the transient frequency is known to be in the frequency range concerned. The transient frequencies need not necessarily be known so accurately in advance, but a rough estimate will be sufficient.

After the bandpass filtering it is possible to determine the transient frequency and cycle time more accurately in the calculating means 16 on the basis of the length of an unfiltered sum current half-cycle. If desired, the determined transient frequency and cycle time can be utilized in the subsequent step, in which the amplitude and the phase angle of the zero sequence voltage U₀ and the transient components of the sum current I_{SUM} are determined by FFT (Fast Fourier Transform). In reality both the charge transient and the discharge transient include a plurality of different frequency components, but in practice, in most cases the transient has only one dominating, network-specific frequency component whose effect in the transient is the greatest, and in connection with the present solution said transient component refers to the frequency of the transient.

Either directly after the bandpass filtering or after the determination of the transient frequency and cycle time, in the calculating means 17 there are determined the amplitudes A(U₀), A(I_{SUM}) and the phase angles ϕ(U₀), ϕ(I_{SUM}) of the transient appearing in the zero sequence voltage U₀ and the sum current I_{SUM} using the FFT. The FFT calculation advantageously uses a continuous Fourier Transform. The length of the calculation window of the continuous Fourier Transform may be fixed, but to obtain a more accurate calculation result the length used may also be the above-determined cycle length of the charge transient. The length of the calculation window refers to the number of signal sample points used at a time in the calculation. The frequency used in the FFT calculation, which frequency refers to the transient frequency component whose amplitude and phase angle are determined, may be a fixed, preset frequency, but further to improve the accuracy of the calculation, it is possible to use the above-determined accurate transient frequency as said frequency. If desired, the fixed frequency used in the calculation is determined by the sampling frequency of the protective relay used in measurement signal sampling and by the number of calculation points used in the FFT calculation. When the identification of the intermittent earth fault is based on the charge transient, the sampling frequency used is advantageously at least 4 kHz, and when the discharge transient is used, the sampling frequency is advantageously at least 10 kHz. For the sake of clarity, Figure 3 does not show a measurement signal sampling means, the operation of which is known per se.

An intermittent earth fault is identified to occur at the feeder observed, in the case of Figure 1 at the feeder 2, when the amplitude A(Uo) of the transient of the network zero sequence voltage U₀ exceeds a predetermined set value U_{0LIMIT}, the amplitude A(I_{SUM}) of the transient of the sum current I_{SUM} of the feeder 2 exceeds a preset set value I_{SUMLIMIT} and the phase angle difference Δ(ϕ(U₀), ϕ(I_{SUM}) of the transient phase angles ϕ(U₀), ϕ(I_{SUM}) of the sum current I_{SUM} and the zero sequence voltage U₀ is within a preset angle value range. In the case of a faulted feeder the angle range is ϕ_{b} ± Δϕ, where ϕ_{b} is -90 degrees and Δϕ is 80 degrees, for instance. The value of Δϕ may vary, however, within the range of 70 to 90 degrees. These conditions must be fulfilled in order that an intermittent earth fault is identified to occur on the feeder observed. The comparison can be implemented in a comparison and deduction means 18, where the difference between phase angles of the transients of the sum current and the zero sequence voltage can be determined as well. The set value U_{0LIMIT} of the amplitude A(U₀) of the transient of the zero sequence voltage U₀ and the set value I_{SUMLIMIT} of the amplitude A(I_{SUM}) of the transient of the sum current I_{SUM} of the feeder 2 are always set according to the operating situation of the network, because the amplitudes are affected by the capacitive earth fault current of the network, the main transformer, the location of the fault in the network, the instantaneous value of phase voltage at the occurrence of the fault and the magnitude of the fault resistance, among other things.

At the minimum, the intermittent earth fault can be identified to occur at the feeder observed as early as on the basis of one fault pulse or fault peak, the amplitudes and the phase angles of the transients of the zero sequence voltage U₀ and the sum current I_{SUM} of the fault pulse fulfilling the conditions presented above. Because the above-described situation also arises when a continuous or permanent earth fault of low impedance is produced in the network, the final decision on the identification of an intermittent earth fault on the feeder observed can be based on the fact that at least a predetermined number, for instance three, of said individual identifications take place in such a manner that the time between individual identifications is shorter than the set recovery time between the identifications. For instance a tripping means 19 can be used for counting the identified fault pulses resulting from the intermittent earth fault on the feeder.

In addition to identification, the solution can also be used for earth fault protection, where on the basis of a control command CTL given by a protective relay 7 the breaker of the faulted feeder is controlled to disconnect. Because the disconnection control of the breaker always leads to interruption in power supply in said network section, it is advantageous if more than one identifications are obtained on the intermittent earth fault on the feeder concerned, for instance the above-mentioned three identifications, before the breaker of the faulted feeder is disconnected.

The apparatus of Figure 3 is implemented in practice as a protective relay 7 of an electricity distribution network, and therefore said parts in Figure 3 are surrounded by a broken line representing the protective relay 7. In practice the parts and operations presented in Figure 3 are implemented with one or more microprocessors or signal processors in the protective relay, where all operations requiring computation are advantageously implemented by means of software executed by the processor.

Thanks to the solution it is possible to achieve reliable identification of the intermittent earth fault, because a phenomenon generated by the intermittent earth fault, and the characteristic variables thereof: amplitude and phase angle, are observed at a frequency range typical thereof. The solution also allows implementation of quick and reliable earth fault protection against the intermittent earth fault, and it further allows easier fault tracing on the basis of the determination of a correct fault direction. In particular the solution based on a charge transient is useful at very low, about 4 kHz, sampling frequencies and the computational capacity required is very reasonable.

On the basis of the network zero sequence voltage U₀ and the sum current I_{SUM} of the unfaulted feeder, in the case of Figure 1 feeder 1, it is correspondingly possible to identify an intermittent earth fault on a feeder other than the feeder observed, i.e. somewhere in the area of the galvanically connected background network. On observing an unfaulted feeder an intermittent earth fault is identified to occur on another feeder when the amplitude A(Uo) of the transient of the zero sequence voltage U₀ exceeds a predetermined set value U_{0LIMIT}, the amplitude A(I_{SUM}) of the transient of the sum current I_{SUM} exceeds a predetermined set value I_{SUMLIMIT} and the phase angle difference Δ(ϕ(U₀), ϕ(I_{SUM}) of the transient phase angles ϕ(U₀), ϕ(I_{SUM}) of the sum current I_{SUM} and the zero sequence voltage U₀ is within a preset angle range. In the case of an unfaulted feeder the angle range is -ϕ_{b} ± Δϕ, where ϕ_{b} is -90 degrees and Δϕ is 80 degrees, for instance. The value of Δϕ may vary, however, within the range of 70 to 90 degrees.

Likewise, when an unfaulted feeder is observed, an intermittent earth fault can be identified to occur in the background network on the basis of not more than one fault pulse or fault peak at the minimum, the amplitudes and the phase angles of the transients of the zero sequence voltage U₀ and the sum current I_{SUM} of the fault pulse fulfilling the above conditions. Also in this case the final decision on the identification of an intermittent earth fault in the background network can be based on the fact that at least a predetermined number, for instance three, of said individual identifications take place in such a manner that the time between individual identifications is shorter than the set recovery time between the identifications.

The identification of the intermittent earth fault, when implemented on the unfaulted feeder, has an advantage that when the current earth fault protection based on the fundamental frequency of the network and used for the protection against continuous, i.e. permanent, earth faults is coordinated with the identification of the intermittent earth fault, the identification implemented at the unfaulted feeder can be utilized for preventing the breaker from being disconnected due to an erroneous start of the conventional earth fault protection in said feeder.

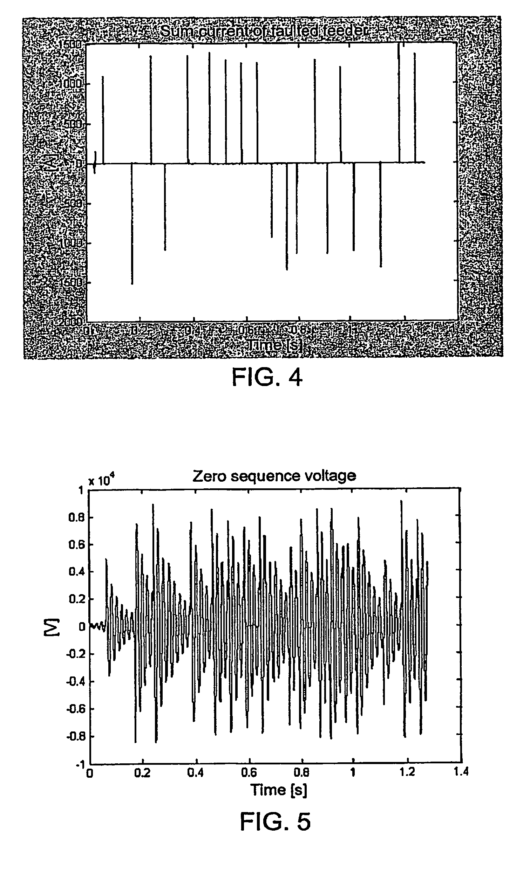

In the following, Figures 4 to 23 illustrate an example of the operation of the method according to the solution both on a faulted feeder and on an unfaulted feeder during an intermittent earth fault in an electricity distribution network. The example of Figures 4 to 23 is based on measurements of the sum current I_{SUM} of the faulted and unfaulted feeders and the zero sequence voltage U₀ of the electricity distribution network performed in a field test measurement in the electricity distribution network. In this exemplary case the identification of the intermittent earth fault is based on the observation of a charge transient of the zero sequence voltage U₀ and the sum current I_{SUM}.

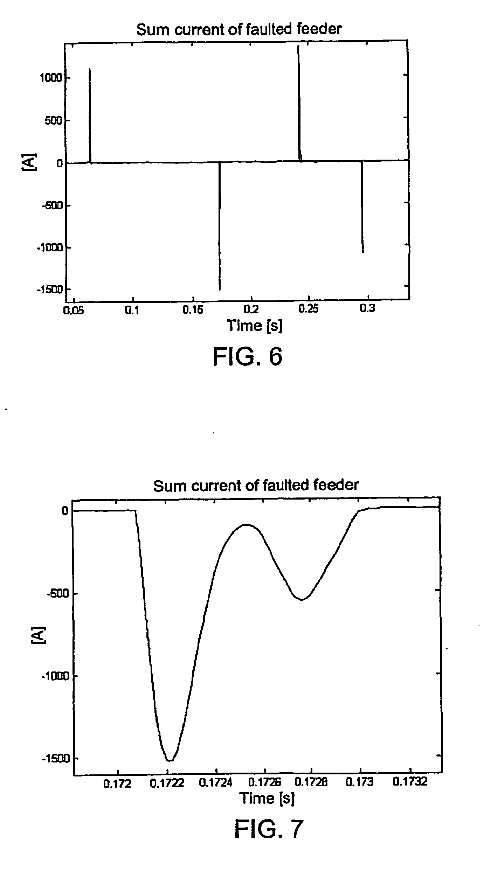

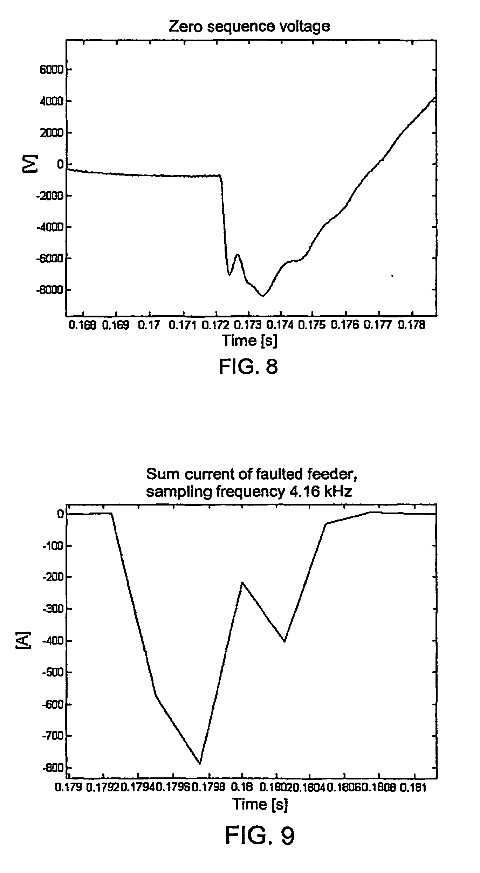

Figure 4 shows the sum current I_{SUM} of the faulted feeder for the period of about 1.2 seconds. Figure 5 shows the zero sequence voltage U₀ of the distribution network for the same period of time. Figures 4 and 5 show clearly a phenomenon typical of the intermittent earth fault, where in the measurement of the sum current I_{SUM} there are a plurality of fault pulses which repeat within a very short period of time and where in the measurement of the zero sequence voltage U₀ a quick rise in the zero sequence voltage appears at the onset moment of the fault and thereafter a slow decrease in the zero sequence voltage value until a next fault occurs and the zero sequence voltage value rises again. Figure 6 shows a detail of Figure 4 and presents the first four sum current pulses. Figure 7, in turn, shows a detail of Figure 6 and presents the second sum current pulse in order of the faulted feeder. Figure 8, in turn, shows a change in the zero sequence voltage corresponding to the sum current pulse of Figure 7. The sampling frequency used in the measurements of Figures 4 to 8 was 50 kHz. Figure 9 shows the sum current pulse of Figure 7, the sampling frequency being 4.16 kHz.

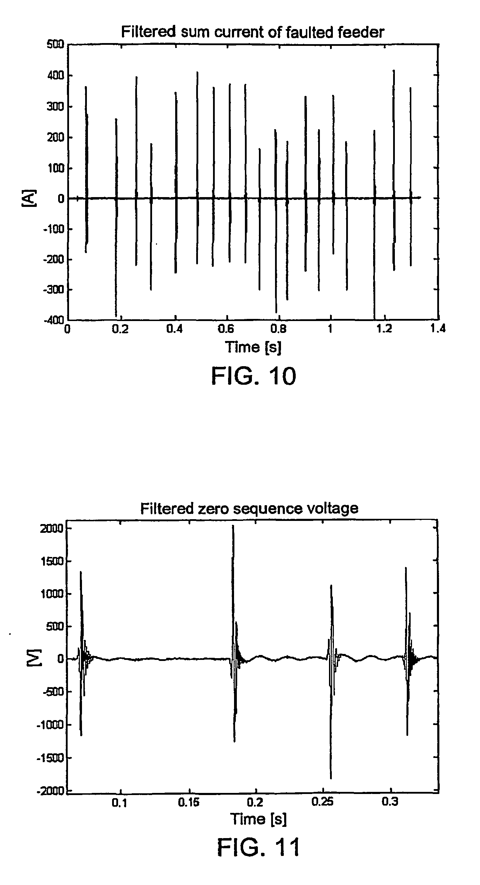

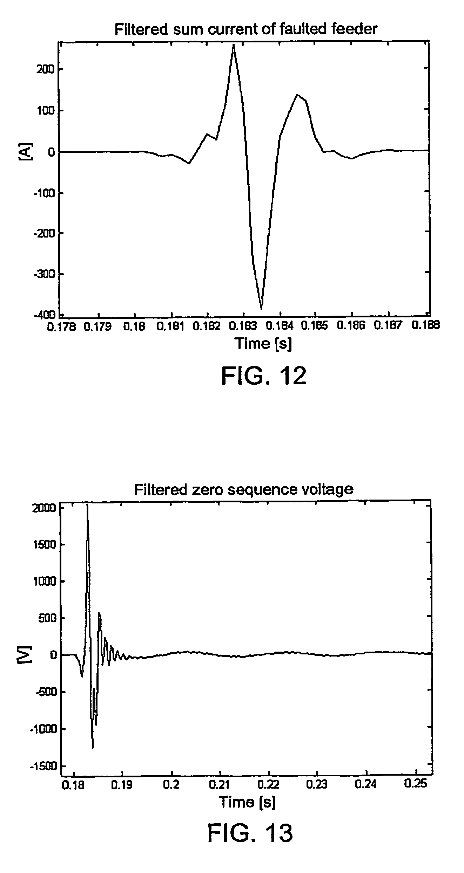

Figure 10 shows the sum current I_{SUM} of the faulted feeder and Figure 11 shows the zero sequence voltage U₀ of the distribution network after bandpass filtering. In this example the lower limit of the bandpass of the filter 15 was 300 Hz and the upper limit was 1200 Hz and the design of the filter 15 employed the Hann window function. Naturally, it is also possible to use other passband frequency limits and window functions. Figure 12 shows a detail of Figure 10 and presents the second sum current pulse in order of the sum current I_{SUM}. Figure 13, in turn, shows a detail of Figure 11 and presents a change in the zero sequence voltage corresponding to the second sum current pulse in order. The effect of the filtering appears as a downward change in the amplitude level of the sum current I_{SUM} and the zero sequence voltage U₀, because apart from the transient component all other frequency components of the sum current and the zero sequence voltage are filtered out.

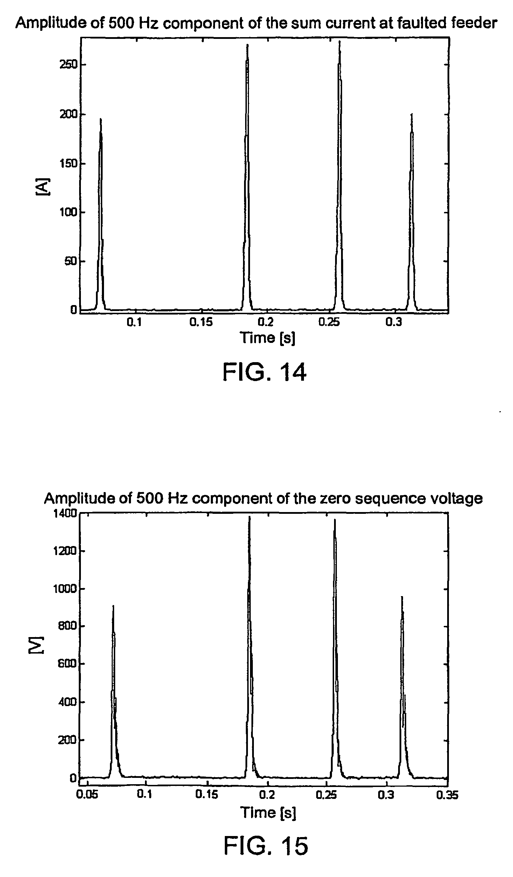

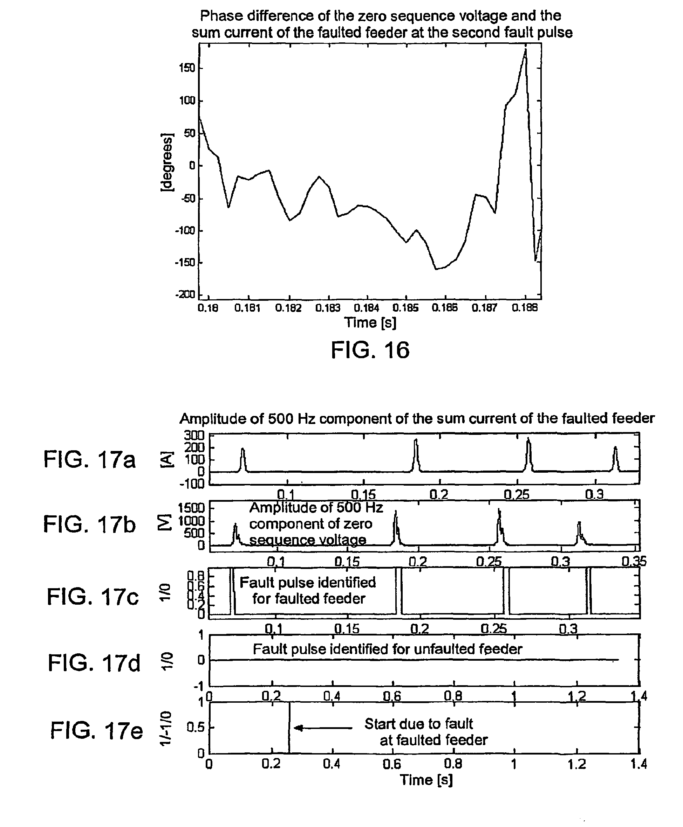

Figure 14 shows the amplitude of the sum current I_{SUM} in the faulted feeder and Figure 15 shows the amplitude of the zero sequence voltage U₀ of the distribution network calculated with a continuous FFT. The frequency used in the FFT calculation is a fixed frequency of 500 Hz, which means that the amplitude of the transient component of 500 Hz was calculated. Figure 16 shows the phase angle difference between the phase angles of the sum current I_{SUM} and the zero sequence voltage U₀ at said frequency of 500 Hz at the second sum current pulse in order. It appears from Figure 16 how said phase angle difference remains within the phase angle range -90° ± 80° characteristic of a faulted feeder during the fault.

Figures 17a, 17b, 17c and 17e show the operation of the method for the first four sum current pulses from the viewpoint of the faulted feeder. Figure 17a shows the amplitude of the sum current component of 500 Hz and Figure 17b shows the amplitude of the zero sequence voltage component of 500 Hz. Rising pulses in the descriptor in Figure 17c represent each sum current pulse being identified as caused by an intermittent earth fault occurring on the feeder observed or monitored, whereas the even descriptor in Figure 17d indicates that on the unfaulted feeder nothing has reacted to the fault in the network. In Figure 17e, the descent of the descriptor from one to zero indicates that on the faulted feeder it was already detected, on the basis of the first sum current pulse, that the fault is occurring on said feeder.

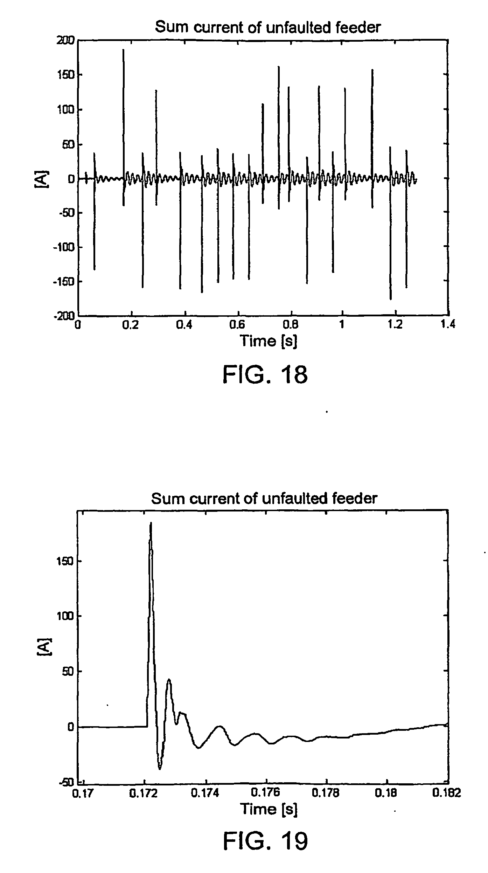

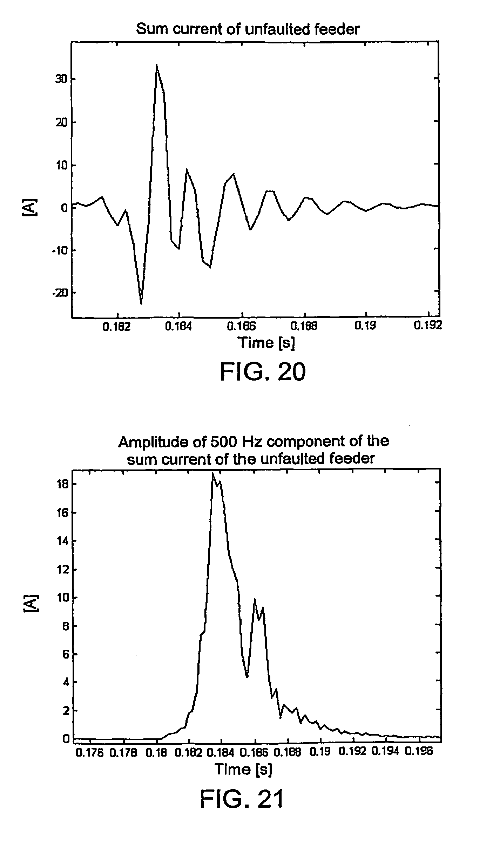

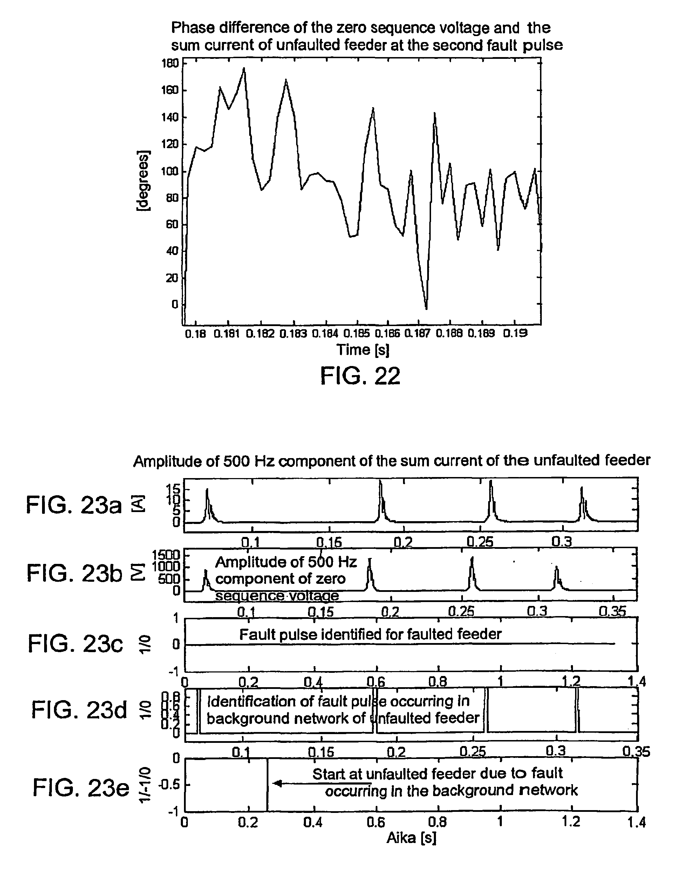

Figure 18 shows the sum current I_{SUM} of an unfaulted feeder in a corresponding exemplary situation. Figure 19 shows a detail of Figure 18 and presents the second sum current pulse in order of the unfaulted feeder. Figure 20 shows the sum current pulse of the unfaulted feeder as in Figure 19 after bandpass filtering. Figure 21 shows the amplitude of the 500 Hz component of the sum current pulse in Figure 20 calculated with a continuous FFT. Figure 22 shows the phase angle difference between the phase angles of the 500 Hz frequency components of the sum current and the zero sequence voltage at the second sum current pulse in order. It appears from Figure 22 how said phase angle difference remains within the above-mentioned phase angle range +90° ± 80° characteristic of the unfaulted feeder.

Figures 23a, 23b, 23c, 23d and 23e show the operation of the method for the first four sum current pulses from the viewpoint of the unfaulted feeder. Figure 23a shows the amplitude of the sum current component of 500 Hz and Figure 23b shows the amplitude of the zero sequence voltage component of 500 Hz. The even descriptor in Figure 23c indicates that on the faulted feeder nothing has reacted to the solution according to the identification conditions of the unfaulted feeder, whereas the pulses in the descriptor in Figure 23d indicate that each sum current pulse is identified as caused by an intermittent earth fault occurring in the background network of the feeder observed and not by a fault occurring at the feeder line observed. In Figure 23e, the descent of the descriptor from zero to minus one indicates that on the unfaulted feeder it has already been detected, on the basis of the first sum current pulse, that the fault is in the background network and not on the feeder observed.

The drawings and the relating description are only intended to illustrate the inventive idea. The details of the invention may vary within the scope of the claims. Thus, in addition to the compensated distribution network, the presented solution can also be utilized correspondingly in isolated neutral distribution networks, i.e. in networks having normally a connection to earth only through direct earth capacitances of the network, because the transient phenomenon is approximately the same both in the isolated networks and in the compensated network. Further, the presented solution can also be applied to electricity distribution networks earthed with resistance, i.e. in networks where a separate earthing resistance is connected between a star point of the secondary winding of the main transformer and earth. Further still, the network topology has no effect on the performance of the solution but it can be used both in radial networks and in loop networks as well as in networks with overhead lines and in cable networks. The solution is also applicable in a corresponding manner to networks where the fundamental frequency of the network differs from 50 Hz, and to networks where the number of phases is other than three.

Instead of the sum current and the zero sequence voltage the identification of an intermittent earth fault in an electricity distribution network can also be implemented on the basis of the network phase variables, i.e. the phase voltage and the phase current. In this solution said phase variables are processed with corresponding signal processing methods, such as filtering, in such a manner that the filtered phase current and the filtered phase voltage substantially comprise only a transient component appearing in the intermittent earth fault, including the charge transients and the discharge transients. In the same way as in the solution based on the sum current and the zero sequence voltage, in the solution based on the phase variables the essential thing is that the protection is based on observing a transient caused by the intermittent earth fault at least at one frequency typical of a charge transient or a discharge transient.

## Claims

1. A method for identifying an intermittent earth fault in an electricity distribution network, in which method the intermittent earth fault is identified on the basis of a zero sequence voltage (U₀) in the electricity distribution network and a sum current of phase currents at the start of a feeder line (1, 2) in the electricity distribution network, in which method
a zero sequence voltage (U₀) of said electricity distribution network is produced,
a sum current (I_{SUM}) of the phase currents (I_{R}, I_{S}, I_{T}) of said feeder line (1, 2) at the start of the feeder line is produced,
the zero sequence voltage (U₀) is filtered such that the filtered zero sequence voltage (U₀) substantially comprises only a transient component appearing in an intermittent earth fault,
the sum current (I_{SUM}) is filtered such that the filtered sum current (I_{SUM}) substantially comprises only a transient component appearing in an intermittent earth fault,
said method being **characterised in that**
the amplitude (A(U₀)) and the phase angle (ϕ(U₀)) of the zero sequence voltage (U₀) transient component is determined at least at one frequency,
the amplitude (A(I_{SUM})) and the phase angle (ϕ(I_{SUM})) of the sum current (I_{SUM}) transient component is determined at least at one frequency,
a phase difference between the phase angles (ϕ(U₀), ϕ(I_{SUM})) of the zero sequence voltage (U₀) and sum current (I_{SUM}) transient components is formed,
the amplitude (A(U₀)) of the zero sequence voltage (U₀) transient component is compared with a predetermined set value (A(U_{0LIMIT})) for the amplitude (A(U₀)) of the zero sequence voltage (U₀),
the amplitude (A(I_{SUM}) of the sum current (I_{SUM}) transient component is compared with a predetermined set value (A(I_{SUMLIMIT})) for the amplitude (A(I_{SUM}) of the sum current (I_{SUM}),
the phase difference between the phase angles (ϕ(U₀), ϕ(I_{SUM})) of the transient components of the zero sequence voltage (U₀) and the sum current (I_{SUM}) is compared with a predetermined set value range of the phase difference, and wherein
the intermittent earth fault is identified to occur on the feeder line (1, 2), for which the amplitude (A(I_{SUM})) and the phase angle (ϕ(I_{SUM})) of the transient component of the sum current (I_{SUM}) have been determined when the amplitudes (A(U₀), A(I_{SUM})) of the transient components of the zero sequence voltage (U₀) and the sum current (I_{SUM}) exceed the corresponding set values (A(U_{0LIMIT}), A(I_{SUMLIMIT})) for the amplitudes and the phase difference between the phase angles (ϕ(U₀), ϕ(I_{SUM})) of the transient components of the zero sequence voltage (U₀) and the sum current (I_{SUM}) is within a set value range determined for the feeder line (1, 2), for which the amplitude (A(I_{SUM})) and the phase angle (ϕ(I_{SUM})) of the transient component of the sum current (I_{SUM}) have been determined, or
the intermittent earth fault is identified to occur on some other feeder line of the galvanically connected electricity distribution network than the one (1, 2) for which the amplitude (A(I_{SUM})) and the phase angle (ϕ(I_{SUM})) of the transient component of the sum current (I_{SUM}) have been determined when the amplitudes (A(U₀), A(I_{SUM})) of the transient components of the zero sequence voltage (U₀) and the sum current (I_{SUM}) exceed the corresponding set values (A(U_{0LIMIT}), A(I_{SUMLIMIT})) for the amplitudes and the phase difference between the phase angles (ϕ(U₀), ϕ(I_{SUM})) of the transient components of the zero sequence voltage (U₀) and the sum current (I_{SUM}) is within a set value range determined for the feeder line other than the one (1, 2) for which the amplitude (A(I_{SUM})) and the phase angle (ϕ(I_{SUM})) of the transient component of the sum current (I_{SUM}) have been determined, and wherein
the final decision on the identification of the intermittent earth fault is based on the fact that at least a predetermined number of individual identifications take place in such a manner that the time between individual identifications is shorter than the set recovery time between the identifications.

2. A method as claimed in claim 1, **characterized in that** when the phase difference between the phase angles (ϕ(U₀), ϕ(I_{SUM})) of the transient components of the zero sequence voltage (U₀) and the sum current (I_{SUM}) is within a set value range ϕ_{b} ± Δϕ, where ϕ_{b} is -90 degrees and Δϕ is 80 degrees, the intermittent earth fault is identified to occur on the feeder (1, 2), for which the amplitude (A(I_{SUM})) and the phase angle (ϕ(I_{SUM})) of the transient component of the sum current (I_{SUM}) have been determined.

3. A method as claimed in claim 2, **characterized by** further setting a control command (CTL) to disconnect a breaker (6) on said feeder line so as to protect the electricity distribution network against the effect of the intermittent earth fault.

4. A method as claimed in claim 1, **characterized in that** when the phase difference between the phase angles (ϕ(U₀), ϕ(I_{SUM})) of the transient components of the zero sequence voltage (U₀) and the sum current (I_{SUM}) is within a set value range -ϕ_{b} ± Δϕ, where ϕ_{b} is -90 degrees and Δϕ is 80 degrees, the intermittent earth fault is identified to occur on some other feeder of the galvanically connected electricity distribution network than the one (1, 2) for which the amplitude (A(I_{SUM})) and the phase angle (ϕ(I_{SUM})) of the transient component of the sum current (I_{SUM}) have been determined.

5. A method as claimed in any one of the preceding claims, **characterized by** determining the amplitudes (A(U₀), A(I_{SUM})) and the phase angles (ϕ(U₀), ϕ(I_{SUM})) of the transient components of the zero sequence voltage (U₀) and the sum current (I_{SUM}) by means of continuous FFT calculation.

6. A method as claimed in claim 5, **characterized by** determining the amplitudes (A(U₀), A(I_{SUM})) and the phase angles (ϕ(U₀), ϕ(I_{SUM})) of the transient components of the zero sequence voltage (U₀) and the sum current (I_{SUM}) using a preset, fixed frequency value.

7. A method as claimed in claim 5, **characterized by** determining at least one frequency for a transient component of the zero sequence voltage (U₀) and the sum current (I_{SUM}) and by determining the amplitudes (A(U₀), A(I_{SUM})) and the phase angles (ϕ(U₀), ϕ(I_{SUM})) of the transient components of the zero sequence voltage (U₀) and the sum current (I_{SUM}) at said frequency value.

8. A method as claimed in claims 7, **characterized in that** at least one frequency of the transient component of the zero sequence voltage (U₀) and the sum current (I_{SUM}) is determined on the basis of the length of one half-cycle of the sum current (I_{SUM}).

9. A method as claimed in any one of the preceding claims, **characterized by** filtering said zero sequence voltage (U₀) and sum current (I_{SUM}) with a bandpass filter.

10. A method as claimed in any one of the preceding claims, **characterized by** producing the zero sequence voltage (U₀) of the electricity distribution network by calculating a mean of instantaneous values of individual phase voltages (U_{R}, U_{S}, U_{T}) and by producing the sum current (I_{SUM}) of the phase currents (I_{R}, I_{S}, I_{T}) by calculating the sum of instantaneous values of individual phase currents (I_{R}, I_{S}, I_{T}).

11. A method as claimed in any one of the preceding claims, **characterized in that** said transient component is a charge transient component.

12. A method as claimed in any one of claims 1 to 10, **characterized in that** said transient component is a discharge transient component.

13. A method as claimed in any one of the preceding claims, **characterized in that** the electricity distribution network is a partly or completely compensated network, an isolated network or a resistance earthed network.

14. An apparatus for identifying an intermittent earth fault in an electricity distribution network, which apparatus is arranged to identify the intermittent earth fault on the basis of a zero sequence voltage (U₀) in the electricity distribution network and a sum current (I_{SUM}) of phase currents (I_{R}, I_{S}, I_{T}) at the start of a feeder line (1, 2) in the electricity distribution network, the apparatus comprising
means for producing a zero sequence voltage (U₀) in the electricity distribution network,
means for producing a sum current (I_{SUM}) of the phase currents (I_{R}, I_{S}, I_{T}) of the feeder line (1, 2) at the start of the feeder line (1, 2),
means for filtering the zero sequence voltage (U₀) such that the filtered zero sequence voltage (U₀) substantially comprises only a transient component appearing in an intermittent earth fault,
means for filtering the sum current (I_{SUM}) such that the filtered sum current (I_{SUM}) substantially comprises a transient component only appearing in the intermittent earth fault,
**characterised in that** said apparatus further comprises
means for determining the amplitude (A(U₀) and the phase angle (ϕ(U₀) of the zero sequence voltage transient component at least at one frequency,
means for determining the amplitude (A(I_{SUM}) and the phase angle (ϕ(I_{SUM})) of the sum current transient component at least at one frequency,
means for forming the phase difference between the phase angles (ϕ(U₀), ϕ(I_{SUM})) of the the transient components of the zero sequence voltage (U₀) and the sum current (I_{SUM}),
means for comparing the amplitude (A(U₀)) of the zero sequence voltage (U₀) transient component with a predetermined set value (A(U_{0LIMIT})) for the amplitude (A(U₀)) of the zero sequence voltage (U₀),
means for comparing the amplitude (A(I_{SUM})) of the sum current (I_{SUM}) transient component with a predetermined set value (A(I_{SUMLIMIT})) for the amplitude A(I_{SUM})) of the sum current (I_{SUM}), and
means for comparing the phase difference between the phase angles (ϕ(U₀), ϕ(I_{SUM})) of the transient components of the zero sequence voltage (U₀) and the sum current (I_{SUM}) with a predetermined set value range of the phase difference, wherein
the apparatus is arranged to identify the intermittent earth fault to occur on the feeder line (1, 2), for which the amplitude (A(I_{SUM})) and the phase angle (ϕ(I_{SUM})) of the transient component of the sum current (I_{SUM}) have been determined, when the amplitudes (A(U₀), A(I_{SUM})) of the transient components of the zero sequence voltage (U₀) and the sum current (I_{SUM}) exceed the corresponding set values (A(U_{0LIMIT}), A(I_{SUMLIMIT})) for the amplitudes and the phase difference between the phase angles (ϕ(U₀), ϕ(I_{SUM})) of the transient components of the zero sequence voltage (U₀) and the sum current (I_{SUM}) is within a set value range determined for the feeder line (1, 2), for which the amplitude (A(I_{SUM})) and the phase angle (ϕ(I_{SUM})) of the transient component of the sum current (I_{SUM}) have been determined or
the apparatus is arranged to identify the intermittent earth fault to occur on some other feeder line of the galvanically connected electricity distribution network than the one (1, 2) for which the amplitude (A(I_{SUM})) and the phase angle (ϕ(I_{SUM})) of the transient component of the sum current (I_{SUM}) have been determined, when the amplitudes (A(U₀), A(I_{SUM})) of the transient components of the zero sequence voltage (U₀) and the sum current (I_{SUM}) exceed the corresponding set values (A(U_{0LIMIT}), A(I_{SUMLIMIT})) for the amplitudes and the phase difference between the phase angles (ϕ(U₀), ϕ(I_{SUM})) of the transient components of the zero sequence voltage (U₀) and the sum current (I_{SUM}) is within a set value range determined for the feeder line other than the one (1, 2) for which the amplitude (A(I_{SUM})) and the phase angle (ϕ(I_{SUM})) of the transient component of the sum current (I_{SUM}) have been determined, and wherein
the apparatus is arranged to identify the final decision on the identification of the intermittent earth fault based on the fact that at least a predetermined number of individual identifications take place in such a manner that the time between individual identifications is shorter than the set recovery time between the identifications.

15. An apparatus as claimed in claim 14, **characterized in that** the apparatus is arranged to identify the intermittent earth fault to occur on the feeder line (1, 2), for which the amplitude (A(I_{SUM})) and the phase angle (ϕ(I_{SUM})) of the transient component of the sum current (I_{SUM}) have been determined, when the phase difference between the phase angles (ϕ(U₀), ϕ(I_{SUM})) of the transient components of the zero sequence voltage (U₀) and / the sum current (I_{SUM}) is within a set value range ϕ_{b} ± Δϕ, where ϕ_{b} is -90 degrees and Δϕ is 80 degrees,

16. An apparatus as claimed in claim 15, **characterized in that** the apparatus also comprises means for setting a control command (CTL) to disconnect a breaker (6) on said feeder line so as to protect the electricity distribution network against the effect of the intermittent earth fault.

17. An apparatus as claimed in claim 14, **characterized in that** the apparatus is arranged to identify the intermittent earth fault to occur on some other feeder line of the galvanically connected electricity distribution network than the one (1, 2) for which the amplitude (A(I_{SUM})) and the phase angle (ϕ(I_{SUM})) of the transient component of the sum current (I_{SUM}) have been determined, when the phase difference between the phase angles (ϕ(U₀), ϕ(I_{SUM})) of the transient components of the zero sequence voltage (U₀) and / the sum current (I_{SUM}) is within a set value range -ϕ_{b} ± Δϕ, where ϕ_{b} is -90 degrees and Δϕ is 80 degrees,

18. An apparatus as claimed in any one of claims 14 to 17, **characterized by** comprising means for determining the amplitudes (A(U₀), A(I_{SUM})) and the phase angles (ϕ(U₀), ϕ(I_{SUM})) of the transient components of the zero sequence voltage (U₀) and the sum current (I_{SUM}) by means of continuous FFT calculation.

19. An apparatus as claimed in claim 18, **characterized by** being arranged to determine the amplitudes (A(U₀), A(I_{SUM})) and the phase angles (ϕ(U₀), ϕ(I_{SUM})) of the transient components of the zero sequence voltage (U₀) and the sum current (I_{SUM}) using a preset, fixed frequency value.

20. An apparatus as claimed in claim 18, **characterized by** comprising means for determining at least one frequency for a transient component of the zero sequence voltage (U₀) and the sum current (I_{SUM}) and by being arranged to determine the amplitudes (A(U₀), A(I_{SUM})) and the phase angles (ϕ(U₀), ϕ(I_{SUM})) of the transient components of the zero sequence voltage (U₀) and the sum current (I_{SUM}) at said frequency value.

21. An apparatus as claimed in claim 20, **characterized by** comprising means for determining at least one frequency for a transient component of the zero sequence voltage (U₀) and the sum current (I_{SUM}) on the basis of the length of one half cycle of the unfiltered sum current (I_{SUM}).

22. An apparatus as claimed in any one of claims 14 to 21, **characterized by** comprising a bandpass filter (15) for filtering said zero sequence voltage (U₀) and said sum current (I_{SUM}).

23. An apparatus as claimed in any one of claims 14 to 22, **characterized by** comprising means for producing the zero sequence voltage (U₀) of the electricity distribution network by calculating a mean of instantaneous values of individual phase voltages (U_{R}, U_{S}, U_{T}) and means for producing the sum current (I_{SUM}) of the phase currents (I_{R}, I_{S}, I_{T}) by calculating the sum of instantaneous values of individual phase currents (I_{R}, I_{S}, I_{T}).

24. An apparatus as claimed in any one of claims 14 to 23, **characterized in that** said transient component is a charge transient component.

25. An apparatus as claimed in any one of claims 14 to 23, **characterized in that** said transient component is a discharge transient component.

26. An apparatus as claimed in any one of claims 14 to 25, **characterized in that** that the electricity distribution network is a partly or completely compensated network, an isolated network or a resistance earthed network.

## Patentansprüche

1. Verfahren zum Identifizieren eines intermittierenden Erdfehlers in einem Elektrizitätsversorgungsnetz, bei welchem Verfahren der intermittierende Erdfehler aufgrund einer Verlagerungsspannung (U₀) im Elektrizitätsversorgungsnetz und eines Summenstroms von Phasenströmen am Anfang einer Zuführungsleitung (1, 2) im Elektrizitätsversorgungsnetz identifiziert wird, bei welchem Verfahren
eine Verlagerungsspannung (U₀) des besagten Elektrizitätsversorgungsnetzes erzeugt wird,
ein Summenstrom (I_{SUM}) der Phasenströme (I_{R}, I_{S}, I_{T}) der besagten Zuführungsleitung (1, 2) am Anfang der Zuführungsleitung erzeugt wird,
die Verlagerungsspannung (U₀) derart gefiltert wird, dass die gefilterte Verlagerungsspannung (U₀) wesentlich eine nur in einem intermittierenden Erdfehler vorkommende transiente Komponente aufweist,
der Summenstrom (I_{SUM}) derart gefiltert wird, dass der gefilterte Summenstrom (I_{SUM}) wesentlich eine nur in einem intermittierenden Erdfehler vorkommende transiente Komponente aufweist,
wobei das besagte Verfahren dadurch **gekenntzeichnet** ist, dass die Amplitude (A(U₀)) und der Phasenwinkel (ϕ(U₀)) der transienten Komponente der Verlagerungsspannung (U₀) wenigstens bei einer Frequenz bestimmt werden,
die Amplitude (A(I_{SUM})) und der Phasenwinkel (ϕ(I_{SUM})) der transienten Komponente des Summenstroms (I_{SUM}) wenigstens bei einer Frequenz bestimmt werden,
eine Phasendifferenz zwischen den Phasenwinkeln (ϕ(U₀), ϕ(I_{SUM})) der transienten Komponenten der Verlagerungsspannung (U₀) und des Summenstroms (I_{SUM}) ausgebildet wird,
die Amplitude (A(U₀)) der transienten Komponente der Verlagerungsspannung (U₀) mit einem vorbestimmten Sollwert (A(U_{0LIMIT})) für die Amplitude (A(U₀)) der Verlagerungsspannung (U₀) verglichen wird,
die Amplitude (A(I_{SUM}) der transienten Komponente des Summenstroms (I_{SUM}) mit einem vorbestimmten Sollwert (A(I_{SUMLIMIT})) für die Amplitude (A(I_{SUM}) des Summenstroms (I_{SUM}) verglichen wird,
die Phasendifferenz zwischen den Phasenwinkeln (ϕ(U₀), ϕ(I_{SUM})) der transienten Komponenten der Verlagerungsspannung (U₀) und des Summenstroms (I_{SUM}) mit einem vorbestimmten Sollwertbereich der Phasendifferenz verglichen wird, und wobei
es identifiziert wird, dass der intermittierende Erdfehler auf der Zuführungsleitung (1, 2) auftritt, für die die Amplitude (A(I_{SUM})) und der Phasenwinkel (ϕ(I_{SUM})) der transienten Komponente des Summenstroms (I_{SUM}) bestimmt worden sind, wenn die Amplituden (A(U₀), A(I_{SUM})) der transienten Komponenten der Verlagerungsspannung (U₀) und des Summenstroms (I_{SUM}) die entsprechenden Sollwerte (A(U_{0LIMIT}), A(I_{SUMLIMIT})) für die Amplituden überschreiten und die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines für die Zuführungsleitung (1, 2) bestimmten Sollwertbereichs ist, für die die Amplitude (A(I_{SUM})) und der Phasenwinkel (ϕ(I_{SUM})) der transienten Komponente des Summenstroms (I_{SUM}) bestimmt worden sind, oder
es identifiziert wird, dass der intermittierende Erdfehler auf einer anderen Zuführungsleitung des galvanisch verbundenen Elektrizitätsversorgungsnetzes auftritt, als auf derjenigen (1, 2), für die die Amplitude (A(I_{SUM})) und der Phasenwinkel (ϕ(I_{SUM})) der transienten Komponente des Summenstroms (I_{SUM}) bestimmt worden sind, wenn die Amplituden (A(U₀), A(I_{SUM})) der transienten Komponenten der Verlagerungsspannung (U₀) und des Summenstroms (I_{SUM}) die entsprechenden Sollwerte (A(U_{0LIMIT}), A(I_{SUMLIMIT})) für die Amplituden überschreiten und die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines für die andere Zuführungsleitung bestimmten Sollwertbereichs ist, als diejenige (1, 2), für die die Amplitude (A(I_{SUM})) und der Phasenwinkel (ϕ(I_{SUM})) der transienten Komponente des Summenstroms (I_{SUM}) bestimmt worden sind, und wobei
die endgültige Entscheidung über die Identifizierung des intermittierenden Erdfehlers auf der Tatsache beruht, dass wenigstens eine vorbestimmte Anzahl von einzelnen Identifizierungen derart stattfinden, dass die Zeit zwischen einzelnen Identifizierungen kürzer als die vorgegebene Wiederbereitschaftszeit zwischen den Identifizierungen ist.

2. Verfahren nach Anspruch 1, **dadurch gekennzeichnet, dass**, wenn die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines Sollwertbereichs ϕ_{b} ± Δϕ ist, worin ϕ_{b} -90 Grad ist und Δϕ 80 Grad ist, es identifiziert wird, dass der intermittierende Erdfehler auf der Zuführungsleitung (1, 2) auftritt, für die die Amplitude (A(I_{SUM})) und der Phasenwinkel (ϕ(I_{SUM})) der transienten Komponente des Summenstroms (I_{SUM}) bestimmt worden sind.

3. Verfahren nach Anspruch 2, **dadurch gekennzeichnet, dass** weiterhin ein Steuerbefehl (CTL) vorgegeben wird, der einen Schalter (6) auf der besagten Zuführungsleitung betätigt zur Unterbrechung derselben, um das Elektrizitätsversorgungsnetz gegen die Wirkung des intermittierenden Erdfehlers zu schützen.

4. Verfahren nach Anspruch 1, **dadurch gekennzeichnet, dass**, wenn die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines Sollwertbereichs -ϕ_{b} ± Δϕ ist, worin ϕ_{b} -90 Grad ist und Δϕ 80 Grad ist, es identifiziert wird, dass der intermittierende Erdfehler auf einer anderen Zuführungsleitung des galvanisch verbundenen Elektrizitätsversorgungsnetzes auftritt, als auf derjenigen (1, 2), für die die Amplitude (A(I_{SUM})) und der Phasenwinkel (ϕ(I_{SUM})) der transienten Komponente des Summenstroms (I_{SUM}) bestimmt worden sind.

5. Verfahren nach einem der vorhergehenden Ansprüche, **dadurch gekennzeichnet, dass** die Amplituden (A(U₀), A(I_{SUM})) und die Phasenwinkel (ϕ(U₀), ϕ(I_{SUM})) der transienten Komponenten der Verlagerungsspannung (U₀) und des Summenstroms (I_{SUM}) durch kontinuierliche FFT-Berechnung bestimmt werden.

6. Verfahren nach Anspruch 5, **dadurch gekennzeichnet, dass** die Amplituden (A(U₀), A(I_{SUM})) und die Phasenwinkel (ϕ(U₀), ϕ(I_{SUM})) der transienten Komponenten der Verlagerungsspannung (U₀) und des Summenstroms (I_{SUM}) anhand eines vorbestimmten festen Frequenzwerts bestimmt werden.

7. Verfahren nach Anspruch 5, **dadurch gekennzeichnet, dass** wenigstens eine Frequenz für eine transiente Komponente der Verlagerungsspannung (U₀) und des Summenstroms (I_{SUM}) bestimmt wird und die Amplituden (A(U₀), A(I_{SUM})) und die Phasenwinkel (ϕ(U₀), ϕ(I_{SUM})) der transienten Komponenten der Verlagerungsspannung (U₀) und des Summenstroms (I_{SUM}) bei der besagten Frequenz bestimmt werden.

8. Verfahren nach Anspruch 7, **dadurch gekennzeichnet, dass** wenigstens eine Frequenz der transienten Komponente der Verlagerungsspannung (U₀) und des Summenstroms (I_{SUM}) aufgrund der Länge eines Halbzyklus des Summenstroms (I_{SUM}) bestimmt wird.

9. Verfahren nach einem der vorhergehenden Ansprüche, **dadurch gekennzeichnet, dass** die besagte Verlagerungsspannung (U₀) und der Summenstrom (I_{SUM}) mit einem Bandpassfilter gefiltert wird.

10. Verfahren nach einem der vorhergehenden Ansprüche, **dadurch gekennzeichnet, dass** die Verlagerungsspannung (U₀) des Elektrizitätsversorgungsnetzes erzeugt wird, indem der Durchschnitt von Momentanwerten von einzelnen Phasenspannungen (U_{R}, U_{S}, U_{T}) berechnet wird, und der Summenstrom (I_{SUM}) der Phasenströme (I_{R}, I_{S}, I_{T}) erzeugt wird, indem die Summe von Momentanwerten von einzelnen Phasenströmen (I_{R}, I_{S}, I_{T}) berechnet wird.

11. Verfahren nach einem der vorhergehenden Ansprüche, **dadurch gekennzeichnet, dass** die besagte transiente Komponente eine ladungstransiente Komponente ist.

12. Verfahren nach einem der Ansprüche 1 bis 10, **dadurch gekennzeichnet, dass** die besagte transiente Komponente eine entladungstransiente Komponente ist.

13. Verfahren nach einem der vorhergehenden Ansprüche, **dadurch gekennzeichnet, dass** das Elektrizitätsversorgungsnetz ein teilweise oder vollständig kompensiertes Netz, ein isoliertes Netz oder ein über eine Resistanz geerdetes Netz ist.

14. Vorrichtung zum Identifizieren eines intermittierenden Erdfehlers in einem Elektrizitätsversorgungsnetz, welche Vorrichtung angeordnet ist, den intermittierenden Erdfehler aufgrund einer Verlagerungsspannung (U₀) im Elektrizitätsversorgungsnetz und eines Summenstroms (I_{SUM}) von Phasenströmen (I_{R}, I_{S}, I_{T}) am Anfang einer Zuführungsleitung (1, 2) im Elektrizitätsversorgungsnetz zu identifizieren, wobei die Vorrichtung aufweist:
Mittel zum Erzeugen einer Verlagerungsspannung (U₀) im Elektrizitätsversorgungsnetz,
Mittel zum Erzeugen eines Summenstroms (I_{SUM}) der Phasenströme (I_{R}, I_{S}, I_{T}) der Zuführungsleitung (1, 2) am Anfang der Zuführungsleitung (1, 2),
Mittel zum Filtern der Verlagerungsspannung (U₀) derart, dass die gefilterte Verlagerungsspannung (U₀) wesentlich eine nur in einem intermittierenden Erdfehler vorkommende transiente Komponente aufweist,
Mittel zum Filtern des Summenstroms (I_{SUM}) derart, dass der gefilterte Summenstrom (I_{SUM}) wesentlich eine nur in einem intermittierenden Erdfehler vorkommende transiente Komponente aufweist,
**dadurch gekennzeichnet, dass** die besagte Vorrichtung weiterhin aufweist: Mittel zum Bestimmen der Amplitude (A(U₀) und des Phasenwinkels (ϕ(U₀) der transienten Komponente der Verlagerungsspannung wenigstens bei einer Frequenz,
Mittel zum Bestimmen der Amplitude (A(I_{SUM}) und des Phasenwinkels (ϕ(I_{SUM})) der transienten Komponente des Summenstroms wenigstens bei einer Frequenz,
Mittel zum Ausbilden der Phasendifferenz zwischen den Phasenwinkeln (ϕ(U₀), ϕ(I_{SUM})) der transienten Komponenten der Verlagerungsspannung (U₀) und des Summenstroms (I_{SUM}),
Mittel zum Vergleichen der Amplitude (A(U₀)) der transienten Komponente der Verlagerungsspannung (U₀) mit einem vorbestimmten Sollwert (A(U_{0LIMIT})) für die Amplitude (A(U₀)) der Verlagerungsspannung (U₀),
Mittel zum Vergleichen der Amplitude (A(I_{SUM})) der transienten Komponente des Summenstroms (I_{SUM}) mit einem vorbestimmten Sollwert (A(I_{SUMLIMIT})) für die Amplitude A(I_{SUM})) des Summenstroms (I_{SUM}) und
Mittel zum Vergleichen der Phasendifferenz zwischen den Phasenwinkeln (ϕ(U₀), ϕ(I_{SUM})) der transienten Komponenten der Verlagerungsspannung (U₀) und des Summenstroms (I_{SUM}) mit einem vorbestimmten Sollwertbereich der Phasendifferenz, wobei
die Vorrichtung angeordnet ist, zu identifizieren, dass der intermittierende Erdfehler auf der Zuführungsleitung (1, 2) auftritt, für die die Amplitude (A(I_{SUM})) und der Phasenwinkel (ϕ(I_{SUM})) der transienten Komponente des Summenstroms (I_{SUM}) bestimmt worden sind, wenn die Amplituden (A(U₀), A(I_{SUM})) der transienten Komponenten der Verlagerungsspannung (U₀) und des Summenstroms (I_{SUM}) die entsprechenden Sollwerte (A(U_{0LIMIT}), A(I_{SUMLIMIT})) für die Amplituden überschreiten und die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines für die Zuführungsleitung (1, 2) bestimmten Sollwertbereichs ist, für die die Amplitude (A(I_{SUM})) und der Phasenwinkel (ϕ(I_{SUM})) der transienten Komponente des Summenstroms (I_{SUM}) bestimmt worden sind, oder
die Vorrichtung angeordnet ist, zu identifizieren, dass der intermittierende Erdfehler auf einer anderen Zuführungsleitung des galvanisch verbundenen Elektrizitätsversorgungsnetzes auftritt, als auf derjenigen (1, 2), für die die Amplitude (A(I_{SUM})) und der Phasenwinkel (ϕ(I_{SUM})) der transienten Komponente des Summenstroms (I_{SUM}) bestimmt worden sind, wenn die Amplituden (A(U₀), A(I_{SUM})) der transienten Komponenten der Verlagerungsspannung (U₀) und des Summenstroms (I_{SUM}) die entsprechenden Sollwerte (A(U_{0LIMIT}), A(I_{SUMLIMIT})) für die Amplituden überschreiten und die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines für die andere Zuführungsleitung bestimmten Sollwertbereichs ist, als diejenige (1, 2), für die die Amplitude (A(I_{SUM})) und der Phasenwinkel (ϕ(I_{SUM})) der transienten Komponente des Summenstroms (I_{SUM}) bestimmt worden sind, und wobei
die Vorrichtung angeordnet ist, die endgültige Entscheidung über die Identifizierung des intermittierenden Erdfehlers aufgrund der Tatsache zu identifizieren, dass wenigstens eine vorbestimmte Anzahl von einzelnen Identifizierungen derart stattfinden, dass die Zeit zwischen einzelnen Identifizierungen kürzer als die festgelegte Wiederbereitschaftszeit zwischen den Identifizierungen ist.

15. Vorrichtung nach Anspruch 14, dadurch **gekennzeich**n e t , dass die Vorrichtung angeordnet ist, zu identifizieren, dass der intermittierende Erdfehler auf der Zuführungsleitung (1, 2) auftritt, für die die Amplitude (A(I_{SUM})) und der Phasenwinkel (ϕ(I_{SUM})) der transienten Komponente des Summenstroms (I_{SUM}) bestimmt worden sind, wenn die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines Sollwertbereichs ϕ_{b} ± Δϕ ist, worin ϕ_{b} -90 Grad und Δϕ 80 Grad ist.

16. Vorrichtung nach Anspruch 15, **dadurch gekennzeichnet, dass** die Vorrichtung auch Mittel zum Festlegen eines Steuerbefehls (CTL) aufweist, um einen Schalter (6) auf der besagten Zuführungsleitung zur Unterbrechung derselben zu betätigen, um das Elektrizitätsversorgungsnetz gegen die Wirkung des intermittierenden Erdfehlers zu schützen.

17. Vorrichtung nach Anspruch 14, **dadurch gekennzeichnet, dass** die Vorrichtung angeordnet ist, zu identifizieren, dass der intermittierende Erdfehler auf einer anderen Zuführungsleitung des galvanisch verbundenen Elektrizitätsversorgungsnetzes auftritt, als auf derjenigen (1, 2), für die die Amplitude (A(I_{SUM})) und der Phasenwinkel (ϕ(I_{SUM})) der transienten Komponente des Summenstroms (I_{SUM}) bestimmt worden sind, wenn die Phasendifferenz zwischen den Phasenwinkeln (ϕ(U₀), ϕ(I_{SUM})) der transienten Komponenten der Verlagerungsspannung (U₀) und des Summenstroms (I_{SUM}) innerhalb eines Sollwertbereichs -ϕ_{b} ± Δϕ ist, worin ϕ_{b} -90 Grad und Δϕ 80 Grad ist.

18. Vorrichtung nach einem der Ansprüche 14 bis 17, **dadurch gekennzeichnet, dass** sie Mittel zum Bestimmen der Amplituden (A(U₀), A(I_{SUM})) und der Phasenwinkel (ϕ(U₀), ϕ(I_{SUM})) der transienten Komponenten der Verlagerungsspannung (U₀) und des Summenstroms (I_{SUM}) durch kontinuierliche FFT-Berechnung aufweist.

19. Vorrichtung nach Anspruch 18, **dadurch gekennzeichnet, dass** sie angeordnet ist, die Amplituden (A(U₀), A(I_{SUM})) und die Phasenwinkel (ϕ(U₀), ϕ(I_{SUM})) der transienten Komponenten der Verlagerungsspannung (U₀) und des Summenstroms (I_{SUM}) anhand eines vorbestimmten festen Frequenzwerts zu bestimmen.

20. Vorrichtung nach Anspruch 18, **dadurch gekennzeichnet, dass** sie Mittel zum Bestimmen wenigstens einer Frequenz für eine transiente Komponente der Verlagerungsspannung (U₀) und des Summenstroms (I_{SUM}) aufweist und angeordnet ist, die Amplituden (A(U₀), A(I_{SUM})) und die Phasenwinkel (ϕ(U₀), ϕ(I_{SUM})) der transienten Komponenten der Verlagerungsspannung (U₀) und des Summenstroms (I_{SUM}) bei der besagten Frequenz zu bestimmen.

21. Vorrichtung nach Anspruch 20, dadurch **gekennzeich**n e t , dass sie Mittel zum Bestimmen wenigstens einer Frequenz für eine transiente Komponente der Verlagerungsspannung (U₀) und des Summenstroms (I_{SUM}) aufgrund der Länge eines Halbzyklus des ungefilterten Summenstroms (I_{SUM}) aufweist.

22. Vorrichtung nach einem der Ansprüche 14 bis 21, **dadurch gekennzeichnet, dass** sie ein Bandpassfilter (15) zum Filtern der besagten Verlagerungsspannung (U₀) und des besagten Summenstroms (I_{SUM}) aufweist.

23. Vorrichtung nach einem der Ansprüche 14 bis 22, **dadurch gekennzeichnet, dass** sie Mittel zum Erzeugen der Verlagerungsspannung (U₀) des Elektrizitätsversorgungsnetzes aufweist, dadurch dass der Durchschnitt von Momentanwerten von einzelnen Phasenspannungen (U_{R}, U_{S}, U_{T}) berechnet wird, und Mittel zum Erzeugen des Summenstroms (I_{SUM}) der Phasenströme (I_{R}, I_{S}, I_{T}) aufweist, dadurch dass die Summe von Momentanwerten von einzelnen Phasenströmen (I_{R}, I_{S}, I_{T}) berechnet wird.

24. Vorrichtung nach einem der Ansprüche 14 bis 23, **dadurch gekennzeichnet, dass** die besagte transiente Komponente eine ladungstransiente Komponente ist.

25. Vorrichtung nach einem der Ansprüche 14 bis 23, **dadurch gekennzeichnet, dass** die besagte transiente Komponente eine entladungstransiente Komponente ist.

26. Vorrichtung nach einem der Ansprüche 14 bis 25, **dadurch gekennzeichnet, dass** das Elektrizitätsversorgungsnetz ein teilweise oder vollständig kompensiertes Netz, ein isoliertes Netz oder ein über eine Resistanz geerdetes Netz ist.

## Revendications

1. Procédé d'identification d'un défaut à la terre intermittent dans un réseau de distribution d'électricité, dans lequel le défaut à la terre intermittent est identifié sur la base d'une tension homopolaire (U₀) dans le réseau de distribution d'électricité et d'un courant de somme de courants de phase au départ d'une ligne d'alimentation (1, 2) dans le réseau de distribution d'électricité, dans lequel
une tension homopolaire (U₀) dudit réseau de distribution d'électricité est produite,
un courant de somme (I_{SUM}) des courants de phase (I_{R}, I_{S}, I_{T}) de ladite ligne d'alimentation (1, 2) au départ de la ligne d'alimentation est produit,
la tension homopolaire (U₀) est filtrée de telle sorte que la tension homopolaire filtrée (U₀) comprenne sensiblement uniquement une composante transitoire apparaissant dans un défaut à la terre intermittent,
le courant de somme (I_{SUM}) est filtré de telle sorte que le courant de somme filtré (I_{SUM}) comprenne sensiblement uniquement une composante transitoire apparaissant dans un défaut à la terre intermittent,
ledit procédé étant **caractérisé en ce que**
l'amplitude (A (U₀)) et l'angle de phase (ϕ(U₀)) de la composante transitoire de la tension homopolaire (U₀) sont déterminés au moins à une fréquence,
l'amplitude (A(I_{SUM})) et l'angle de phase (ϕ(I_{SUM})) de la composante transitoire du courant de somme (I_{SUM}) sont déterminés au moins à une fréquence,
une différence de phase entre les angles de phase (ϕ(U₀), ϕ(I_{SUM})) des composantes transitoires de la tension homopolaire (U₀) et du courant de somme (I_{SUM}) est formée,
l'amplitude (A(U₀)) de la composante transitoire de la tension homopolaire (U₀) est comparée avec une valeur de consigne prédéterminée (A(U_{0LIMIT})) pour l'amplitude (A(U₀)) de la tension homopolaire (U₀),
l'amplitude (A(I_{SUM})) de la composante transitoire du courant de somme (I_{SUM}) est comparée avec une valeur de consigne prédéterminée (A(I_{SUMLIMIT})) pour l'amplitude (A(I_{SUM})) du courant de somme (I_{SUM}),
la différence de phase entre les angles de phase (ϕ(U₀) , ϕ(I_{SUM})) des composantes transitoires de la tension homopolaire (U₀) et du courant de somme (I_{SUM}) est comparée avec une fourchette de valeurs de consigne prédéterminée de la différence de phase, et dans lequel
le défaut à la terre intermittent est identifié comme apparaissant sur la ligne d'alimentation (1, 2) pour laquelle l'amplitude (A(I_{SUM})) et l'angle de phase (ϕ(I_{SUM})) de la composante transitoire du courant de somme ((I_{SUM}) ont été déterminés lorsque les amplitudes (A(U₀), A(I_{SUM})) des composantes transitoires de la tension homopolaire (U₀) et du courant de somme (I_{SUM}) dépassent les valeurs de consigne correspondantes (A(U0_{LIMIT}), A(I_{SUMLIMIT})) pour les amplitudes et la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne déterminée pour la ligne d'alimentation (1, 2) pour laquelle l'amplitude (A(I_{SUM})) et l'angle de phase (ϕ(I_{SUM})) de la composante transitoire du courant de somme (I_{SUM}) ont été déterminés, ou
le défaut à la terre intermittent est identifié comme apparaissant sur une autre ligne d'alimentation du réseau de distribution d'électricité galvaniquement connecté que celle (1, 2) pour laquelle l'amplitude (A(I_{SUM})) et l'angle de phase (ϕ(I_{SUM})) de la composante transitoire du courant de somme (I_{SUM}) ont été déterminés lorsque les amplitudes (A(U₀), A(I_{SUM})) des composantes transitoires de la tension homopolaire (U₀) et du courant de somme (I_{SUM}) dépassent les valeurs de consigne correspondantes (A(U_{0LIMIT}), A (I_{SUMLIMIT})) pour les amplitudes et la différence de phase entre les angles de phase (ϕ(U₀), ϕ(I_{suM})) des composantes transitoires de la tension homopolaire (U₀) et du courant de somme (I_{SUM}) se situe dans une fourchette de valeurs de consigne déterminée pour la ligne d'alimentation autre que celle (1, 2) pour laquelle l'amplitude (A(I_{SUM})) et l'angle de phase (ϕ(I_{SUM})) de la composante transitoire du courant de somme (I_{SUM}) ont été déterminés, et dans lequel
la décision finale sur l'identification du défaut à la terre intermittent est basée sur le fait qu'au moins un nombre prédéterminé d'identifications individuelles ont lieu de telle sorte que le temps entre des indentifications individuelles est plus court que le temps de récupération fixé entre les identifications.

2. Procédé selon la revendication 1, **caractérisé en ce que** lorsque la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne ϕ_{b} ± Δϕ, où ϕ_{b} correspond à -90 degrés et Δϕ correspond à 80 degrés, le défaut à la terre intermittent est identifié comme apparaissant sur la ligne d'alimentation (1, 2) pour laquelle l'amplitude (A(I_{SUM})) et l'angle de phase (ϕ(I_{SUM})) de la composante transitoire du courant de somme (I_{SUM}) ont été déterminés.

3. Procédé selon la revendication 2, **caractérisé en outre par** l'établissement d'une instruction de commande (CTL) pour déconnecter un sectionneur (6) sur ladite ligne d'alimentation de façon à protéger le réseau de distribution d'électricité contre l'effet du défaut à la terre intermittent.

4. Procédé selon la revendication 1, **caractérisé en ce que** lorsque la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne -ϕ_{b} ± Δϕ, où ϕ_{b} correspond à -90 degrés et Δϕ correspond à 80 degrés, le défaut à la terre intermittent est identifié comme apparaissant sur une autre ligne d'alimentation du réseau de distribution d'électricité galvaniquement connecté que celle (1, 2) pour laquelle l'amplitude (A(I_{SUM})) et l'angle de phase (ϕ(I_{SUM})) de la composante transitoire du courant de somme (I_{SUM}) ont été déterminés.

5. Procédé selon l'une quelconque des revendications précédentes, **caractérisé par** la détermination des amplitudes (A(U₀), A(I_{SUM})) et des angles de phase (ϕ(U₀), ϕ(I_{SUM})) des composantes transitoires de la tension homopolaire (U₀) et du courant de somme (I_{SUM}) au moyen d'un calcul TFR continu.

6. Procédé selon la revendication 5, **caractérisé par** la détermination des amplitudes (A(U₀), A(I_{SUM})) et des angles de phase (ϕ(U₀), ϕ(I_{SUM})) des composantes transitoires de la tension homopolaire (U₀) et du courant de somme (I_{SUM}) en utilisant une valeur de fréquence fixe prédéfinie.

7. Procédé selon la revendication 5, **caractérisé par** la détermination d'au moins une fréquence pour une composante transitoire de la tension homopolaire (U₀) et du courant de somme (I_{SUM}) et par la détermination des amplitudes (A(U₀), A(I_{SUM})) et des angles de phase (ϕ(U₀), ϕ(I_{SUM})) des composantes transitoires de la tension homopolaire (U₀) et du courant de somme (I_{SUM}) à ladite valeur de fréquence.

8. Procédé selon la revendication 7, **caractérisé en ce qu'**au moins une fréquence de la composante transitoire de la tension homopolaire (U₀) et du courant de somme (I_{SUM}) est déterminée sur la base de la longueur d'un demi-cycle du courant de somme (I_{SUM}).

9. Procédé selon l'une quelconque des revendications précédentes, **caractérisé par** le filtrage desdits tension homopolaire (U₀) et courant de somme (I_{SUM}) avec un filtre passe-bande.

10. Procédé selon l'une quelconque des revendications précédentes, **caractérisé par** la production de la tension homopolaire (U₀) du réseau de distribution d'électricité en calculant une moyenne de valeurs instantanées de tensions de phase individuelles (U_{R}, U_{S}, U_{T}) et par la production du courant de somme (I_{SUM}) des courants de phase (I_{R}, I_{S}, I_{T}) en calculant la somme de valeurs instantanées de courants de phase individuels (I_{R}, I_{S}, I_{T}).

11. Procédé selon l'une quelconque des revendications précédentes, **caractérisé en ce que** ladite composante transitoire est une composante transitoire de charge.

12. Procédé selon l'une quelconque des revendications 1 à 10, **caractérisé en ce que** ladite composante transitoire est une composante transitoire de décharge.

13. Procédé selon l'une quelconque des revendications précédentes, **caractérisé en ce que** le réseau de distribution d'électricité est un réseau partiellement ou entièrement compensé, un réseau isolé ou un réseau mis à la terre par résistance.

14. Appareil d'identification d'un défaut à la terre intermittent dans un réseau de distribution d'électricité, lequel appareil est agencé pour identifier la défaut à la terre intermittent sur la base d'une tension homopolaire (U₀) dans le réseau de distribution d'électricité et d'un courant de somme (I_{SUM}) de courants de phase (I_{R}, I_{S}, I_{T}) au départ de la ligne d'alimentation (1, 2) dans le réseau de distribution d'électricité, l'appareil comprenant
un moyen de production d'une tension homopolaire (U₀) dans le réseau de distribution d'électricité,
un moyen de production d'un courant de somme (I_{SUM}) des courants de phase (I_{R}, I_{S}, I_{T}) de la ligne d'alimentation (1, 2) au départ de la ligne d'alimentation (1, 2),
un moyen de filtrage de la tension homopolaire (U₀) de telle sorte que la tension homopolaire filtrée (U₀) comprenne sensiblement uniquement une composante transitoire apparaissant dans un défaut à la terre intermittent,
un moyen de filtrage du courant de somme (I_{SUM}) de telle sorte que le courant de somme filtré (I_{SUM}) comprenne sensiblement une composante transitoire apparaissant uniquement dans le défaut à la terre intermittent,
**caractérisé en ce que** ledit appareil comprend en outre
un moyen de détermination de l'amplitude (A(U₀) et de l'angle de phase (ϕ(U₀)) de la composante transitoire de la tension homopolaire au moins à une fréquence,
un moyen de détermination de l'amplitude (A(I_{SUM}) et de l'angle de phase (ϕ(I_{SUM})) de la composante transitoire du courant de somme au moins à une fréquence,
un moyen de formation de la différence de phase entre les angles de phase (ϕ(U₀), ϕ(I_{SUM})) des composantes transitoires de la tension homopolaire (U₀) et du courant de somme (I_{SUM}),
un moyen de comparaison de l'amplitude (A(U₀)) de la composante transitoire de la tension homopolaire (U₀) avec une valeur de consigne prédéterminée (A(U_{0LIMIT})) pour l'amplitude (A(U₀)) de la tension homopolaire (U₀),
un moyen de comparaison de l'amplitude (A(I_{SUM})) de la composante transitoire du courant de somme (I_{SUM}) avec une valeur de consigne prédéterminée (A(I_{SUMLIMIT})) pour l'amplitude (A(I_{SUM})) du courant de somme (I_{SUM}), et
un moyen de comparaison de la différence de phase entre les angles de phase (ϕ(U₀), ϕ(I_{SUM})) des composantes transitoires de la tension homopolaire (U₀) et du courant de somme (I_{SUM}) avec une fourchette de valeurs de consigne prédéterminée de la différence de phase, dans lequel
l'appareil est agencé pour identifier le défaut à la terre intermittent comme apparaissant sur la ligne d'alimentation (1, 2) pour laquelle l'amplitude (A(I_{SUM})) et l'angle de phase (ϕ(I_{SUM})) de la composante transitoire du courant de somme (I_{SUM}) ont été déterminés, lorsque les amplitudes (A(U₀), A(I_{SUM})) des composantes transitoires de la tension homopolaire (U₀) et du courant de somme (I_{SUM}) dépassent les valeurs de consigne correspondantes (A(U_{0LIMIT}), A (I_{SUMLIMIT})) pour les amplitudes et la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne déterminée pour la ligne d'alimentation (1, 2) pour laquelle l'amplitude (A(I_{SUM})) et l'angle de phase (ϕ(I_{SUM})) de la composante transitoire du courant de somme (I_{SUM}) ont été déterminés, ou
l'appareil est agencé pour identifier le défaut à la terre intermittent comme apparaissant sur une autre ligne d'alimentation du réseau de distribution d'électricité galvaniquement connecté que celle (1, 2) pour laquelle l'amplitude (A(I_{SUM})) et l'angle de phase (ϕ(I_{SUM})) de la composante transitoire du courant de somme (I_{SUM}) ont été déterminés, lorsque les amplitudes (A(U₀), A(I_{SUM})) des composantes transitoires de la tension homopolaire (U₀) et du courant de somme (I_{SUM}) dépassent les valeurs de consigne correspondantes (A(U_{0LIMIT}), A(I_{SUMLIMIT})) pour les amplitudes et la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne déterminée pour la ligne d'alimentation autre que celle (1, 2) pour laquelle l'amplitude (A(I_{SUM})) et l'angle de phase (ϕ(I_{SUM})) de la composante transitoire du courant de somme (I_{SUM}) ont été déterminés, et dans lequel
l'appareil est agencé pour identifier la décision finale sur l'identification du défaut à la terre intermittent sur la base du fait qu'au moins un nombre prédéterminé d'identifications individuelles ont lieu de telle sorte que le temps entre les identifications individuelles est plus court que le temps de récupération fixé entre les identifications.

15. Appareil selon la revendication 14, **caractérisé en ce que** l'appareil est agencé pour identifier le défaut à la terre intermittent comme apparaissant sur la ligne d'alimentation (1, 2) pour laquelle l'amplitude (A(I_{SUM})) et l'angle de phase (ϕ(I_{SUM})) de la composante transitoire du courant de somme (I_{SUM}) ont été déterminés, lorsque la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne ϕ_{b} ± Δϕ, où ϕ_{b} correspond à -90 degrés et Δϕ correspond à 80 degrés.

16. Appareil selon la revendication 15, **caractérisé en ce que** l'appareil comprend également un moyen d'établissement d'une instruction de commande (CTL) pour déconnecter un sectionneur (6) sur ladite ligne d'alimentation de façon à protéger le réseau de distribution d'électricité contre l'effet du défaut à la terre intermittent.

17. Appareil selon la revendication 14, **caractérisé en ce que** l'appareil est agencé pour identifier le défaut à la terre intermittent comme apparaissant sur une autre ligne d'alimentation du réseau de distribution d'électricité connecté galvaniquement que celle (1, 2) pour laquelle l'amplitude (A(I_{SUM})) et l'angle de phase (ϕ(I_{SUM})) de la composante transitoire du courant de somme (I_{SUM}) ont été déterminés, lorsque la différence de phase entre les angles de phase (ϕ(U₀), ϕ(I_{SUM})) des composantes transitoires de la tension homopolaire (U₀) et du courant de somme (I_{SUM}) se situe dans une fourchette de valeurs de consigne -ϕ_{b} ± Δϕ, où ϕ_{b} correspond à -90 degrés et Δϕ correspond à 80 degrés.

18. Appareil selon l'une quelconque des revendications 14 à 17, **caractérisé par** le fait de comprendre un moyen de détermination des amplitudes (A(U₀), A(I_{SUM})) et des angles de phase (ϕ(U₀), ϕ(I_{SUM})) des composantes transitoires de la tension homopolaire (U₀) et du courant de somme (I_{SUM}) au moyen d'un calcul TFR continu.

19. Appareil selon la revendication 18, **caractérisé par** le fait d'être agencé pour déterminer les amplitudes (A(U₀), A(I_{SUM})) et les angles de phase (ϕ(U₀), ϕ(I_{SUM})) des composantes transitoires de la tension homopolaire (U₀) et du courant de somme (I_{SUM}) en utilisant une valeur de fréquence fixe prédéfinie.

20. Appareil selon la revendication 18, **caractérisé par** le fait de comprendre un moyen de détermination d'au moins une fréquence pour une composante transitoire de la tension homopolaire (U₀) et du courant de somme (I_{SUM}) et par le fait d'être agencé pour déterminer les amplitudes (A(U₀), A(I_{SUM})) et les angles de phase (ϕ(U₀), ϕ(I_{SUM})) des composantes transitoires de la tension homopolaire (U₀) et du courant de somme (I_{SUM}) à ladite valeur de fréquence.

21. Appareil selon la revendication 20, **caractérisé par** le fait de comprendre un moyen de détermination d'au moins une fréquence pour une composante transitoire de la tension homopolaire (U₀) et du courant de somme (I_{SUM}) sur la base de la longueur d'un demi-cycle du courant de somme non filtré (I_{SUM}).

22. Appareil selon l'une quelconque des revendications 14 à 21, **caractérisé par** le fait de comprendre un filtre passe-bande (15) pour filtrer ladite tension homopolaire (U₀) et ledit courant de somme (I_{SUM}).

23. Appareil selon l'une quelconque des revendications 14 à 22, **caractérisé par** le fait de comprendre un moyen de production de la tension homopolaire (U₀) du réseau de distribution d'électricité en calculant une moyenne de valeurs instantanées de tensions de phase individuelles (U_{R}, U_{S}, U_{T}) et un moyen de production du courant de somme (I_{SUM}) des courants de phase (I_{R}, I_{S}, I_{T}) en calculant la somme de valeurs instantanées de courants de phase individuels (I_{R}, I_{S}, I_{T}) .

24. Appareil selon l'une quelconque des revendications 14 à 23, **caractérisé en ce que** ladite composante transitoire est une composante transitoire de charge.

25. Appareil selon l'une quelconque de revendications 14 à 23, **caractérisé en ce que** ladite composante transitoire est une composante transitoire de décharge.

26. Appareil selon l'une quelconque des revendications 14 à 25, **caractérisé en ce que** le réseau de distribution d'électricité est un réseau partiellement ou entièrement compensé, un réseau isolé ou un réseau mis à la terre par résistance.
